(19) Europäisches Patentamt
European Patent Office
Office européen des brevets

(11) Veröffentlichungsnummer: **0 321 398 B1**

(12) **EUROPÄISCHE PATENTSCHRIFT**

(45) Veröffentlichungstag der Patentschrift: **17.08.94**

(51) Int. Cl.5: **C08G 73/10**, C08L 79/08, G03F 7/00

(21) Anmeldenummer: **88810832.1**

(22) Anmeldetag: **06.12.88**

Die Akte enthält technische Angaben, die nach dem Eingang der Anmeldung eingereicht wurden und die nicht in dieser Patentschrift enthalten sind.

# (54) Autophotovernetzbare Copolyimide und Polyimidzusammensetzungen.

(30) Priorität: **15.12.87 US 133407**

(43) Veröffentlichungstag der Anmeldung:
**21.06.89 Patentblatt 89/25**

(45) Bekanntmachung des Hinweises auf die Patenterteilung:
**17.08.94 Patentblatt 94/33**

(84) Benannte Vertragsstaaten:
**BE CH DE FR GB IT LI NL**

(56) Entgegenhaltungen:
**EP-A- 0 181 837**
**EP-A- 0 214 103**
**EP-A- 0 252 883**
**EP-A- 0 253 765**

(73) Patentinhaber: **CIBA-GEIGY AG**
**Klybeckstrasse 141**
**CH-4002 Basel (CH)**

(72) Erfinder: **Rohde, Ottmar, Dr.**
**Bärenfelserstrasse 34**
**CH-4057 Basel (CH)**
Erfinder: **Jasne, Stanley Jay**
**1 Pamela Road**
**Peekskill New York 10566 (US)**
Erfinder: **Pfeifer, Josef, Dr.**
**Brunnmattstrasse 32**
**CH-4106 Therwil (CH)**

**EP 0 321 398 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft neue Copolyimide, Zusammensetzungen enthaltend diese Verbindungen und mindestens ein weiteres Polyimid, ein Verfahren zur Erzeugung von Schutzschichten oder Abbildungen, sowie die Verwendung besagter Verbindungen oder Gemische als photovernetzbare Komponenten bei der Herstellung elektronischer Bauteile.

Lösliche und gleichzeitig photostrukturierbare Polyimide sind aus den EP-A-132,221, -134,752, -162,017 und -181,837 bekannt.

Aus den EP-A-92,524 und -141,781 sind strahlungsempfindliche Beschichtungsmittel bekannt, die ein lösliches Polyimid und mindestens ein Vernetzungsmittel, beispielsweise ein organisches chromophores Polyazid, enthalten.

Photostrukturierbare Polyimide sind als Schutzschichten oder Zwischenschichten bei der Herstellung elektronischer Bauelemente von potentiellem Interesse. Schichten aus diesen Materialien sind hoch temperaturbeständig und chemisch inert, so dass sie auch in Prozessschritten eingesetzt werden können, bei denen hohe Temperaturen und aggressive chemische Bedingungen vorliegen.

Vorbekannte autophotovernetzbare Polyimide enthalten neben einer in die Polymerkette eingebauten Sensibilisatoreinheit, beispielsweise einem Rest der Benzophenon- oder der Thioxanthontetracarbonsäure, Diaminreste mit zum Stickstoffatom $\alpha$- oder o-ständigem aliphatisch gebundenem Wasserstoff, beispielsweise o,o-dialkylsubstituierte aromatische Diaminreste. In der Regel steigt die Photoempfindlichkeit mit dem Anteil des eingebauten Sensibilisators. Bei den gewünschten hohen Photoempfindlichkeiten war man bislang also auf möglichst hohe Sensibilisatorkonzentrationen festgelegt, weshalb die Variationsmöglichkeiten anderer Polymereigenschaften, wie thermische Stabilität, Glasübergangstemperatur, Löslichkeit oder Wasseraufnahmebeständigkeit, eingeschränkt waren.

Ebenso konnten die optischen Eigenschaften dieser Photosysteme, wie Lichtabsorption und spektrale Empfindlichkeit, nur in geringem Masse verändert werden.

Es wurde jetzt gefunden, dass geringe Anteile an Thioxanthontetracarbonsäureresten überraschenderweise zu Polyimiden mit einer hohen Photoempfindlichkeit führen. Dies ist auch aus ökonomischen Gründen interessant, da solche Systeme nur geringe Anteile der aufwendig herzustellenden Thioxanthontetracarbonsäure enthalten.

Durch den Einbau geringer Mengen des Sensibilisators in ein an sich nicht-photoaktives Material lassen sich also hoch-aktive Verbindungen herstellen, ohne dass dabei die physikalisch-chemischen Eigenschaften des Grundpolymeren wesentlich verändert werden.

Es wurde ferner gefunden, dass sich diese Copolymeren mit strukturverwandten, aber nicht unbedingt photoaktiven Polyimiden zu photoaktiven Materialien kombinieren lassen. Damit werden die Variationsmöglichkeiten hoch photoempfindlicher Polyimide bezüglich Materialeigenschaften, wie thermischer Stabilität, Glasübergangstemperatur, Wasseraufnahme, Elastizitätsmodul, Bruchdehnung und thermischem Ausdehnungskoeffizient, entscheidend vergrössert. Ferner lassen sich die Systeme in ihrem optischen und photochemischen Verhalten variieren. So kann man z.B. die optische Absorption auf vorgegebene Schichtdicken und Substrate gezielt einstellen.

Die vorliegende Erfindung betrifft Copolyimide aus 100-70 Mol% an wiederkehrenden Struktureinheiten der Formel I und 0-30 Mol% an wiederkehrenden Struktureinheiten der Formel II

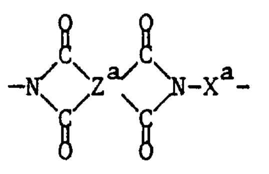 (I), 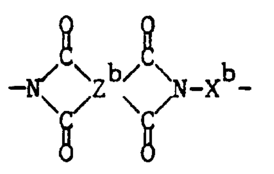 (II),

worin $Z^a$ ein vierwertiger aromatischer Rest einer Tetracarbonsäure ist, der sich von Thioxanthontetracarbonsäure unterscheidet und dessen Carboxylgruppen sich jeweils paarweise in ortho- oder peri-Position zueinander befinden, $X^a$ ein zweiwertiger aromatischer Rest eines Diamins ist, der in mindestens einer ortho-Position zu mindestens einem Stickstoffatom einen Kohlenwasserstoffsubstituenten mit mindestens einem aliphatischen $\alpha$-Wasserstoffatom trägt oder $X^a$ ein Rest der Formel III ist

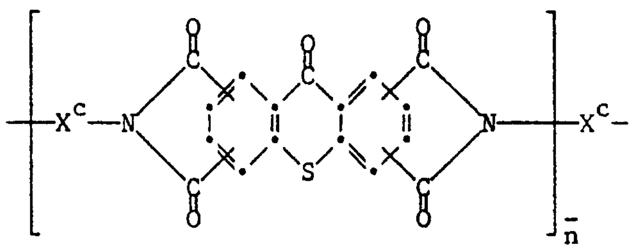 (III);

worin $X^c$ ein zweiwertiger aromatischer Rest eines Diamins ist, der in ortho-Position zu beiden Stickstoffatomen jeweils mindestens einen einwertigen Kohlenwasserstoffsubstituenten mit mindestens einem aliphatischen $\alpha$-Wasserstoffatom trägt, $\bar{n}$ einen Mittelwert von 1,0 bis 2,5 annimmt,

$Z^b$ eine der Bedeutungen von $Z^a$ annimmt und $X^b$ ein aliphatischer, cycloaliphatischer, aromatischer oder araliphatischer Rest eines Diamins ausgenommen eines Restes der Formel III darstellt, mit der Massgabe, dass der Anteil der Reste der Formel III in Formel I so gewählt wird, dass die Menge der Thioxanthontetracarbonsäurereste, bezogen auf die Gesamtmenge der Tetracarbonsäureeinheiten des Copolyimids, zwischen 1 und 30 Mol % beträgt.

$Z^a$ und $Z^b$ können ein- oder mehrkernige, bevorzugt einkernige oder zweikernige, carbocyclisch-aromatische oder hetereocyclisch-aromatische Reste, ausgenommen Thioxanthonreste, sein. Mehrkernige Reste können kondensiert oder bevorzugt über ein Brückglied miteinander verbunden sein.

Beispiele für geeignete Reste $Z^a$ und $Z^b$ findet man in der EP-A-181,837, deren Beschreibung auch Gegenstand der vorliegenden Beschreibung ist.

Bevorzugte Reste $Z^a$ und $Z^b$ entsprechen den Formeln IV bis IX

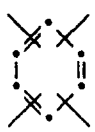 (IV), 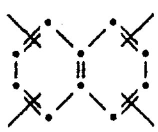 (V), 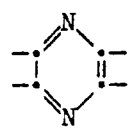 (VI),

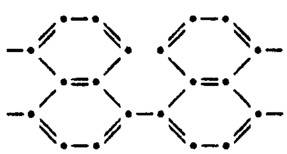 (VII), 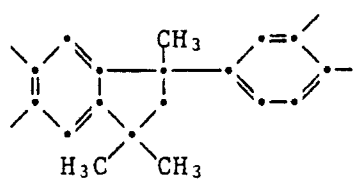 (VIII) und

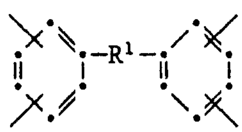 (IX),

worin die freien Bindungen sich jeweils paarweise in ortho-Position zueinander befinden, $R^1$ eine Gruppe der Formeln -CO-, $-CH_2-$, $-C(CH_3)_2-$, $-C(CF_3)_2-$, -O-, -S-, $-SO_2-$, $-NR^2-$, $-SiR^3R^4-$, $-SiR^3R^4-O-SiR^3R^4-$ und $-O-R^5-SiR^3R^4-O-SiR^3R^4-R^5-O-$ darstellt, $R^2$ Wasserstoff oder $C_1$-$C_6$Alkyl bedeutet, $R^3$ und $R^4$ unabhängig voneinander $C_1$-$C_6$Alkyl, $C_1$-$C_6$Perfluoralkyl, $C_1$-$C_6$Alkoxy oder $C_1$-$C_6$-Perfluoralkoxy sind und $R^5$ Alkylen vorzugsweise $C_2$-$C_4$Alkylen ist. Vorzugsweise ist $R^1$ -CO- oder $-C(CF_3)_2-$.

Weitere bevorzugte Reste $Z^a$ und $Z^b$ entsprechen den Formeln X und XI

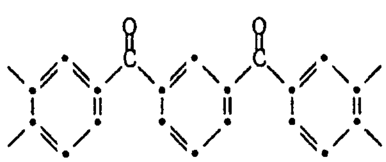 (X), 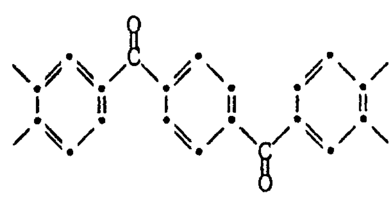 (XI).

Polyimide enthaltend Reste diese Typs sind aus der EP-A-162,017 bekannt. Weitere bevorzugte Reste $Z^a$ und $Z^b$ entsprechen den Formeln XII bis XIV

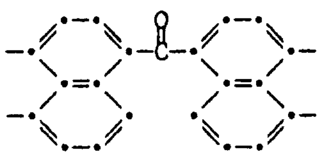 (XII), 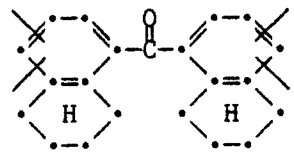 (XIII),

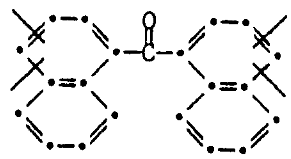 (XIV).

Polyimide enthaltend Reste dieses Typs sind aus der EP-A-181,837 bekannt.

Der aromatische Diaminrest $X^a$ muss bestimmte Substituenten tragen und er muss ein bestimmtes Substitutionsmuster aufweisen.

So muss im von Formel III abweichenden Diaminrest $X^a$ mindestens eine ortho-Position zu einem Stickstoffatom substituiert sein. Es können aber auch mehrere oder alle vier ortho-Positionen zu den Stickstoffatomen oder mögliche weitere Positionen des aromatischen Kerns substituiert sein.

Der ortho-Substituent kann ein einwertiger Kohlenwasserstoffrest mit mindestens einem aliphatischen $\alpha$-Wasserstoffatom sein oder es kann sich um einen zweiwertigen Kohlenwasserstoffrest handeln, der mindestens ein $\alpha$-Wasserstoffatom aufweist und der zusammen mit dem aromatischen Kern ein kondensiertes System ausbildet, beispielsweise eine Alkylenkette.

Weitere Substituenten in ortho-Position oder in nicht-ortho-Position können auch anderer Natur sein, beispielsweise Halogenatome, wie Chlor. Beispiele für Kohlenwasserstoffsubstituenten mit mindestens einem aliphatischen $\alpha$-Wasserstoffatom sind Alkyl, das gegebenenfalls in der Kette durch Sauerstoff- oder Schwefelatome unterbrochen sein kann, Cycloalkyl, Aralkyl oder, im Falle von zweiwertigen Substituenten, auch Alkylen.

Bevorzugte einwertige Kohlenwasserstoffsubstituenten sind $C_1$-$C_6$Alkyl, Cyclohexyl oder Benzyl, ganz besonders bevorzugt $C_1$-$C_4$Alkyl und insbesondere Methyl und Ethyl.

Beispiele für geeignete Reste $X^a$ findet man in der EP-A-181,837. Der von Formel III abweichende Diaminrest $X^a$ besitzt besonders bevorzugt die gleiche Bedeutung wie der Diaminrest $X^c$ in Formel III.

$X^c$ ist ebenfalls ein speziell substituierter aromatischer Diaminrest. Die Substituenten sind einwertige Kohlenwasserstoffreste, die mindestens ein aliphatisches $\alpha$-Wasserstoffatom aufweisen. Es müssen jedoch beide Stickstoffatome mindestens einen ortho-Substituenten aufweisen. Dabei kann es sich, in bezug auf die ortho-Substituenten, um asymmetrisch substituierte Reste $X^c$ oder bevorzugt um symmetrisch substituierte Reste $X^c$ handeln. Beispiele für geeignete Reste $X^c$ findet man in der EP-A-181,837.

Bei den $X^a$ und $X^c$ zugrundeliegenden aromatischen Diaminresten handelt es sich im allgemeinen um substituierte carbocyclisch-aromatische Reste mit Kernen von 6 bis 22 C-Atomen. Diese Reste können einkernig sein oder mehrkernige kondensierte oder über Brückengruppen mit einander verbundene aromatische Systeme darstellen. Vorzugsweise handelt es sich dabei um substituierte Phenylenreste oder um zwei über eine direkte Bindung oder zwei über eine Brückengruppe $R^1$, wie oben für Reste der Formel IX definiert, verbundene substituierte 1,3- oder 1,4-Phenylenreste.

Die Strukturelemente der Formel II werden gegebenenfalls in Mengen von bis zu 30 Mol%, vorzugsweise bis zu 20 Mol%, bezogen auf das Gesamtpolymere, in das erfindungsgemässe Copolyimid einkondensiert, um Eigenschaften, wie beispielsweise Haftvermögen oder Polarität, des Polymeren zu modifizieren.

Beispiele für die Diaminkomponente $X^b$ in Formel II sind in der EP-A-181,837 zu finden.

Beispiele für aliphatische Reste $X^b$ sind $C_2$-$C_{20}$Alkylenreste, die gegebenenfalls durch Sauerstoff- oder Schwefelatome in der Kette unterbrochen sein können, wie Ethylen, Tri-, Tetra-, Penta-, Hexa-, Hepta-, Octa-, Nona-, Deca-, Dodeca-, Tetradeca, Hexadeca-, Octadeca- oder Eicosamethylen oder Di-, Tri- oder Tetra-(oxaethylen), -(oxapropylen) oder -(oxabutylyen).

Unter aliphatischen Resten $X^b$ sind im Rahmen dieser Beschreibung auch Siloxanreste mit aliphatischen Substituenten oder siloxanmodifizierte aliphatische Reste zu verstehen.

Von den aliphatischen Resten $X^b$ sind insbesondere siloxangruppenhaltige Reste zu erwähnen. Beispiele für diese Gruppen sind in der EP-A-132,221 oder in der EP-A-54,426 zu finden.

Beispiele für cycloaliphatische Reste $X^b$ sind 1,2-, 1,3- oder 1,4-Cyclopentylen oder -Cyclohexylen.

Beispiele für aromatische Diaminreste $X^b$ sind Arylenreste mit 6 bis 22 C-Atomen. Diese Reste können einkernig sein oder mehrkernige kondensierte oder über Brückengruppen miteinander verbundene aromatische Systeme darstellen. Vorzugsweise handelt es sich dabei um Phenylenreste, wie 1,3- oder 1,4-Phenylen oder um über eine direkte Bindung oder über eine Brückengruppe $-R^1-$, wie oben für Reste der Formel IX definiert, verbundene 1,3- oder 1,4-Phenylenreste, wie 4,4'-Diphenylmethan, 4,4'-Diphenylether oder 4,4'-Diphenylsulfon.

Es kann sich aber auch um substituierte aromatische Reste handeln, wie beispielsweise die für $X^a$ - (ausgenommen Reste der Formel III) oder $X^c$ definierten Gruppen.

Als araliphatischer Rest ist $X^b$ beispielsweise Xylylen.

Handelt es sich bei irgendwelchen Resten um $C_1$-$C_6$Alkyl, $C_1$-$C_6$Alkoxy, $C_1$-$C_6$Perfluoralkyl oder $C_1$-$C_6$Perfluoralkoxy, so können die Alkyl- oder Perfluoralkylreste geradkettig oder verzweigt sein.

Beispiele für solche Reste sind Methyl, Ethyl, n-Propyl, Isopropyl, n-Butyl, sek.Butyl, tert.Butyl, n-Pentyl, n-Hexyl sowie die entsprechenden Perfluoralkyl-, Alkoxy- oder Perfluoralkoxygruppen.

Bevorzugt werden die geradkettigen Reste.

Im Thioxanthonrest der Formel III befinden sich die das Imidsystem ausbildenden Carbonylgruppen jeweils paarweise in ortho-Position zueinander. Bevorzugt werden die Reste der Formel III, worin die Carbonylgruppen sich in 3,3',4,4'-Position befinden.

Der Index $\overline{n}$ ist vorzugsweise ein Mittelwert (Zahlenmittel) von 1,0 bis 1,8, ganz besonders von 1,0 bis 1,5. Der Anteil der Thioxanthonreste, bezogen auf die Gesamtmenge der Tetracarbonsäureeinheiten des Copolyimids, beträgt bevorzugt 2,0 bis 20 Mol %, besonders bevorzugt 3,0 bis 15 Mol%, und ganz besonders bevorzugt 5,0 bis 15 Mol%.

Bevorzugt werden Copolyimide mit den wiederkehrenden Struktureinheiten der Formel I und gegebenenfalls der Formel II, wie oben definiert, worin $Z^a$ und $Z^b$ Reste der Formeln IV und/oder IX sind.

Ganz besonders bevorzugt werden Copolyimide mit den wiederkehrenden Struktureinheiten der Formel I und gegebenenfalls der Formel II, worin $Z^a$ und $Z^b$ Reste der Formeln IV und/oder IX sind und $R^1$ -CO-, -O-, $-CH_2-$, $-C(CH_3)_2-$ und insbesondere $-C(CF_3)_2-$ bedeutet.

Ebenfalls bevorzugt werden Copolyimide aus den wiederkehrenden Struktureinheiten der Formel I und gegebenenfalls der Formel II, worin der Anteil der Thioxanthonreste, bezogen auf die Gesamtmenge der Tetracarbonsäureeinheiten des Copolyimids, 5,0 bis 15 Mol% beträgt.

Ganz besonders bevorzugt werden Copolyimide aus den wiederkehrenden Struktureinheiten der Formel I und gegebenenfalls der Formel II, worin $\overline{n}$ einen Mittelwert von 1,0 bis 1,5 annimmt.

Ebenfalls besonders bevorzugt werden Copolyimide aus den wiederkehrenden Struktureinheiten der Formel I und gegebenenfalls der Formel II, worin alle Reste $X^a$, die keine Reste der Formel III sind, zweiwertige Reste eines aromatischen Diamins sind, das in ortho-Position, bevorzugt in beiden ortho-Positionen, zu beiden Stickstoffatomen jeweils mindestens einen einwertigen Kohlenwasserstoffrest mit aliphatischen $\alpha$-Wasserstoffatomen, bevorzugt einen $C_1$-$C_6$Alkylrest, trägt und worin die Reste $X^c$ in Formel III sich von aromatischen Diaminen ableiten, in denen beide ortho-Positionen beider Stickstoffatome jeweils einwertige Kohlenwasserstoffreste mit aliphatischen $\alpha$-Wasserstoffatomen, bevorzugt $C_1$-$C_6$-Alkylreste, tragen, und worin $X^b$, falls vorhanden, insbesondere ein siloxanmodifizierter Alkylenrest ist.

Ganz besonders bevorzugt werden Copolyimide aus den wiederkehrenden Struktureinheiten der Formel I und gegebenenfalls der Formel II, worin alle Reste $X^a$, $X^b$ und $X^c$ die gleiche Bedeutung aufweisen.

Besonders bevorzugte Diaminreste bei diesen bevorzugten Ausführungsformen sind die Gruppen der Formeln XV bis XVIII

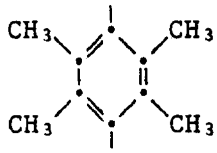 (XV), 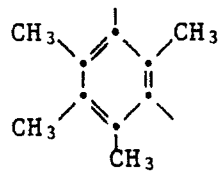 (XVI),

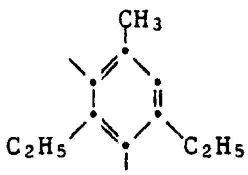 (XVII), 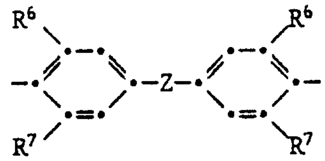 (XVIII),

worin Z eine direkte Bindung ist oder -O-, $-CH_2-$ oder $-C(CF_3)_2-$bedeutet und $R^6$ und $R^7$ unabhängig voneinander $C_1$-$C_6$ Alkyl, insbesondere Methyl oder Ethyl sind.

Ganz besonders bevorzugt werden Reste der Formel XVIII, worin Z $-CH_2-$ oder $-C(CF_3)_2-$ ist, und $R^6$ und $R^7$ Methyl oder Ethyl sind.

Ganz besonders bevorzugt werden Copolyimide bestehend aus wiederkehrenden Struktureinheiten der Formel I, worin alle Reste $X^c$ und die von Formel III abweichenden Reste $X^a$ sich von aromatischen Diaminen ableiten, in denen beide ortho-Positionen beider Stickstoffatome jeweils einwertige Kohlenwasserstoffreste mit aliphatischen $\alpha$-Wasserstoffatomen, insbesondere $C_1$-$C_6$ Alkylgruppen, tragen und ganz besonders bevorzugt Gruppen der Formeln XV bis XVIII sind.

Die erfindungsgemässen Copolyimide weisen mittlere Molekulargewichte (Gewichtsmittel $\overline{M}_w$) von mindestens 5 000, vorzugsweise mindestens 10 000 auf. Die obere Grenze richtet sich im wesentlichen nach Eigenschaften, die die Verarbeitbarkeit bestimmen, wie z.B. deren Löslichkeit. Sie kann bis zu 500 000, vorzugsweise 100 000 und besonders bis zu 60 000 betragen. Es kann sich ferner um statistische Copolyimide oder um Blockcopolyimide handeln. Sie werden nach üblichen Verfahren in hierfür vorgesehenen Einrichtungen hergestellt.

Die Herstellung der erfindungsgemässen Copolyimide erfolgt zweckmässig durch Polykondensation der entsprechenden Tetracarbonsäuren mit den entsprechenden Diaminen. Anstelle der Tetracarbonsäuren lassen sich auch deren polyimidbildende Derivate, beispielsweise deren Dianhydride, Carbonsäurechloride, Tetraalkylester oder Alkylhalbester, einsetzen. Die Polykondensation kann, je nach der Natur der Diaminreste $X^a$, $X^b$ und $X^c$, unterschiedlich duchgeführt werden.

Handelt es sich bei $X^a$, $X^b$ und $X^c$ jeweils um aromatische Diaminreste, welche in ortho-Position zu beiden Stickstoffatomen jeweils mindestens einen einwertigen Kohlenwasserstoffsubstituenten mit aliphatischen $\alpha$-Wasserstoffatomen tragen, so kann die Polykondensation durch direkte Umsetzung der Tetracarbonsäuren der Formeln XIX, XX und gegebenenfalls XXI oder deren polyimidbildenden Derivaten, vorzugsweise den Dianhydriden, mit im wesentlichen äquivalenten Mengen eines oder mehrerer Diamine der Formeln XXII, XXIII und gegebenenfalls XXIV in an sich bekannter Weise vorgenommen werden

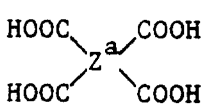 (XIX), 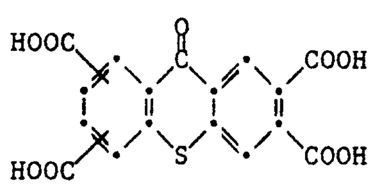 (XX),

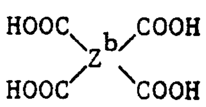 (XXI),

$H_2N$-$X^d$-$NH_2$ (XXII), $H_2N$-$X^c$-$NH_2$ (XXIII),

$H_2N$-$X^e$-$NH_2$ (XXIV),

worin $Z^a$, $Z^b$ und $X^c$ die weiter oben definierte Bedeutung besitzen und $X^d$ und $X^e$ eine der für $X^c$ definierten Bedeutungen annehmen können (Verfahren a). Die Ausgangsverbindungen der Formeln XIX bis XXIV sind

an sich bekannt und beispielsweise in den weiter oben erwähnten Patentanmeldungen betreffend autophotovernetzbare Polyimide beschrieben.

Der Anteil der Thioxanthontetracarbonsäure beträgt bei dieser Ausführungsform zwischen 1 und 30 Mol%, bezogen auf die Menge der Reste XIX bis XXI.

Ein weiteres Herstellungsverfahren (Verfahren b) eignet sich zur Synthese der gemäss Verfahren a erhältlichen Copolyimide oder der übrigen erfindungsgemässen Copolyimide mit Diaminresten $X^a$, welche nicht der Formel III entsprechen und die nicht in den ortho-Positionen zu beiden Stickstoffatomen jeweils einen einwertigen Kohlenwasserstoffsubstituenten mit mindestens einem aliphatischen $\alpha$-Wasserstoffatom tragen, beispielsweise mit einfach ortho-substituierten aromatischen Diaminresten $X^a$ oder $X^b$, oder mit nicht-aromatischen Diaminresten $X^b$. Bei Verfahren b wird die Polykondensation in zwei Stufen ausgeführt. Zunächst wird ein Vorkondensat der Formel XXV hergestellt und gegebenenfalls aufgetrennt und isoliert

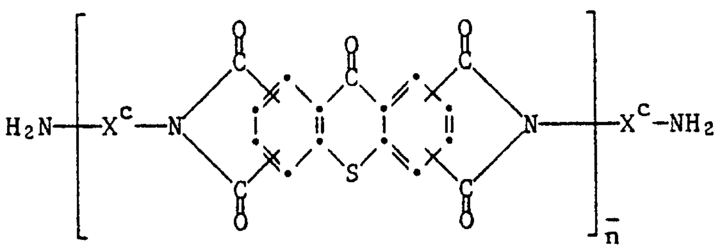

(XXV),

indem man eine Verbindung der Formel XX oder eines ihrer polyimidbildenden Derivate mit einem Ueberschuss eines Diamins der Formel XXIII in an sich bekannter Weise polykondensiert. Dabei ist das molare Verhältnis der beiden Komponenten so zu wählen, dass sich ein Mittelwert $\bar{n}$ zwischen 1,0 und 2,5 ausbildet. Diese Auswahlkriterien sind dem Fachmann auf dem Gebiet der Polykondensationsverfahren an sich bekannt.

Zweckmässigerweise wählt man ein molares Verhältnis von Tetracarbonsäure(derivat) zu Diamin von 1:1,5 bis 1:20, bevorzugt von 1:2 bis 1:10. Das Vorkondensat der Formel XXV wird dann in einer zweiten Stufe mit den restlichen Tetracarbonsäure- und gegebenenfalls Diaminkomponenten der Formeln XIX, XXI, XXVI und XXVII in an sich bekannter Weise polykondensiert

$H_2N\text{-}X^f\text{-}NH_2$ (XXVI) und $H_2N\text{-}X^b\text{-}NH_2$ (XVII);

dabei besitzt $X^f$ eine der für $X^a$ definierten Bedeutungen mit Ausnahme der Formel III und $X^b$ besitzt die weiter oben definierte Bedeutung.

Die Mengenverhältnisse der Komponenten der Formeln XIX und gegebenenfalls XXI, XXVI und XXVII in dieser zweiten Stufe wählt man zweckmässig so, dass der Gesamtmenge der Tetracarbonsäure(derivate) eine praktisch äquivalente Gesamtmenge der Diamine entspricht. Die Menge an Diamin XXV wird so ausgewählt, dass der Gehalt der Thioxanthonreste im Copolymeren der oben definierten Menge entspricht. Die Ausgangsverbindungen der Formeln XXVI und XXVII sind ebenfalls bekannt und beispielsweise in den oben erwähnten Patentanmeldungen betreffend autophotovernetzbare Polyimide beschrieben.

Die Polykondensationen werden vorzugsweise in Lösung vorgenommen. Als Lösungsmittel verwendet man gegenüber den Reaktanden inerte polare organische Lösungsmittel. Beispiele dafür sind weiter unten aufgeführt.

Die Polykondensationen verlaufen, je nach Reaktionstemperatur, zunächst bis zur Vorstufe der Polyamidsäure, welche anschliessend unter Wasserabspaltung cyclisiert wird. Die Cyclisierung kann thermisch erfolgen oder sie wird vorteilhaft unter Einwirkung von wasserentziehenden Mitteln, wie Carbonsäureanhydriden, z.B. Essigsäureanhydrid, oder tertiären Aminen, wie Triethylamin, vorgenommen.

Die Reaktionstemperaturen sind dem Fachmann auf dem Gebiet der Polykondensationen an sich bekannt. Bevorzugte Reaktionstemperaturen liegen zwischen -10 und +20 °C.

Die erfindungsgemässen Copolyimide A) lassen sich mit strukturverwandten, aber nicht unbedingt photoaktiven, Polyimiden B) zu photoaktiven Materialien mit hoher Strahlungsempfindlichkeit kombinieren.

Für den Fall, dass die Komponente B) ein Polyimid mit einem grossen Anteil an Benzophenontetracarbonsäureresten ist, lassen sich hoch strahlungsempfindliche Kombinationen auch mit einer modifizierten Komponente A') herstellen, die einen Anteil an Thioxanthontetracarbonsäureresten von 20 - 100 Mol%, bezogen auf die Gesamtzahl der Tetracarbonsäureeinheiten in Komponente A'), aufweist.

Auswahlkriterium in allen diesen Fällen ist die Gesamtmenge der Thioxanthoncarbonsäurereste in der Mischung, die 1,0 bis 30 Mol%, bezogen auf alle Tetracarbonsäurereste der Polyimidmischung, beträgt. Ferner müssen die Tetracarbonsäure- und Diaminkomponenten beider Polyimidkomponenten so beschaffen sein, dass eine Mischbarkeit beider Komponenten ineinander gewährleistet ist.

Die Erfindung betrifft auch Zusammensetzungen enthaltend als Polyimidkomponenten im wesentlichen

A) ein Copolyimid oder eine Mischung von Copolyimiden aus 100-70 Mol%, insbesondere 100-80 Mol%, an wiederkehrenden Struktureinheiten der Formel I und 0-30 Mol%, insbesondere 0-20 Mol%, an wiederkehrenden Struktureinheiten der Formel II wie oben definiert, wobei die Gesamtmenge an Thioxanthonresten in Komponente A), bezogen auf die Gesamtmenge aller Tetracarbonsäurereste dieser Komponente, 2,0 bis 40 Mol% beträgt, oder

A') ein Polyimid oder eine Mischung von Polyimiden aus 100-20 Mol% an wiederkehrenden Struktureinheiten der Formel XXVIII, 0-80 Mol% an wiederkehrenden Struktureinheiten der Formel XXIX und 0-30 Mol%, insbesondere 0-20 Mol%, an wiederkehrenden Struktureinheiten der Formel XXX

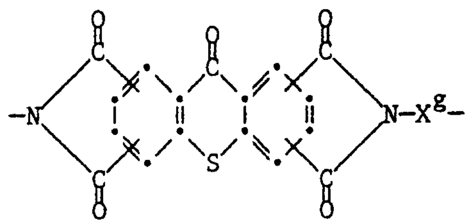 (XXVIII),

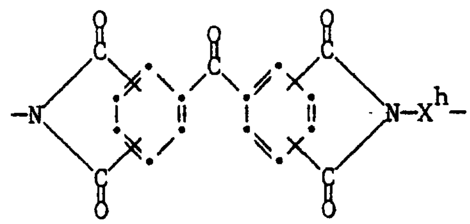 (XXIX), 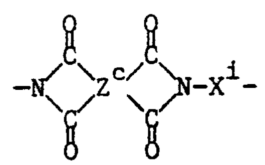 (XXX),

worin $Z^c$ eine der für $Z^a$ definierten Bedeutungen annehmen kann und $X^g$, $X^h$ und $X^i$ unabhängig voneinander eine der für $X^c$ definierten Bedeutungen annehmen können, und

B) ein Polyimid oder ein Gemisch von Polyimiden aus 100-80 Mol% an wiederkehrenden Struktureinheiten der Formel XXXI und aus 0-20 Mol% an wiederkehrenden Struktureinheiten der Formel XXXII

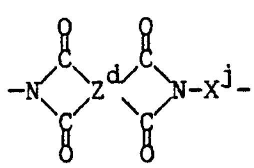 (XXXI), 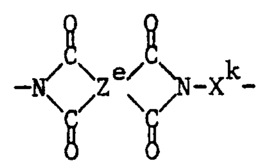 (XXXII),

worin $Z^d$ und $Z^e$ unabhängig voneinander eine der für $Z^a$ definierten Bedeutungen annehmen können, $X^j$ eine der für $X^a$ definierten Bedeutungen mit Ausnahme der Formel III annehmen kann und $X^k$ eine der für $X^b$ definierten Bedeutungen annehmen kann,

wobei im Falle der A)/B) Mischungen gilt, dass wenigstens 70 Mol% der Reste $Z^d$ und gegebenenfalls $Z^e$ in Komponente B), bezogen auf die Gesamtmenge dieser Reste, mit den Resten $Z^a$ und gegebenenfalls $Z^b$ in Komponente A) identisch sein müssen und wenigstens 70 Mol% der Reste $X^j$ und gegebenenfalls $X^k$ in Komponente B), bezogen auf die Gesamtmenge dieser Reste, mit den von Formel III abweichenden Resten $X^a$ und gegebenenfalls den Resten $X^b$ in Komponente A) identisch sein müssen, oder wobei mindestens 40 Mol%, bevorzugt mindestens 45 Mol%, der Reste $X^j$ und gegebenenfalls $X^k$ in Komponente B), bezogen auf die Gesamtmenge dieser Reste, mit den Resten $X^g$ und gegebenenfalls $X^h$ und $X^i$ in Komponente A') identisch sein müssen, mit der Massgabe, dass

die Kombination A')/B) für den Fall möglich ist, dass 80-100 Mol% der Tetracarbonsäurereste der Komponente B) sich von Benzophenontetracarbonsäure ableiten, und dass in allen anderen Fällen die Kombinationen A)/B) möglich sind,

und dass bei allen Kombinationen A)/B) und A')/B) die Menge der Komponenten A) oder A') so gewählt

wird, dass die Menge der Thioxanthontetracarbonsäurereste, bezogen auf die Gesamtmenge der Tetracarbonsäurereste in der Polyimidmischung, zwischen 1,0 und 30 Mol%, insbesondere zwischen 1,0 und 20 Mol%, liegt.

Der Gehalt an Thioxanthonresten im Polyimid der Komponente A) weicht etwas von der obigen Definition der erfindungsgemässen Polyimide ab, da durch die Verdünnung mit der Komponente B) der Gesamtgehalt an Thioxanthontetracarbonsäureresten herabgesetzt wird. Die Polyimide der Komponente A) lassen sich in Analogie zu den oben beschriebenen Verfahren durch Einsatz der entsprechenden Mengen der Ausgangsverbindungen XIX bis XXVII erhalten.

Die Polyimide der Komponente A') sind im allgemeinen aus der EP-A-181,837 bekannt.

Die Polyimide der Komponente B) sind an sich aus den EP-A-132,221 und -134,752 bekannt.

Die Tetracarbonsäurereste $Z^c$, $Z^d$ und $Z^e$ nehmen bevorzugt eine der weiter oben für $Z^a$ gegebenen bevorzugten Bedeutungen an.

Besonders bevorzugt handelt es sich dabei um Reste der Formel IV und IX, insbesondere um Reste der Formel IX, worin $R^1$ -CO-, -O-, $-CH_2-$ oder $-C(CF_3)_2-$ ist.

Die Diaminreste $X^g$, $X^h$ und $X^i$ nehmen vorzugsweise eine der weiter oben für $X^c$ gegebenen bevorzugten Bedeutungen an.

Der Diaminrest $X^j$ nimmt vorzugsweise eine der weiter oben für $X^a$ gegebenen bevorzugten Bedeutungen an.

Der Diaminrest $X^k$ nimmt vorzugsweise eine der weiter oben für $X^b$ gegebenen bevorzugten Bedeutungen an.

Ganz besonders bevorzugt handelt es sich bei $X^g$, $X^h$, $X^i$, $X^j$ und $X^k$ um Reste der Formeln XV bis XVIII.

Bevorzugte Polyimidzusammensetzungen aus A) und B) oder aus A') und B) enthalten eine Gesamtmenge an Thioxanthontetracarbonsäureresten zwischen 1,0 und 15 Mol%, ganz besonders zwischen 3,0 und 15 Mol%, bezogen auf die Gesamtmenge aller Tetracarbonsäurereste in der Polyimidmischung.

Besonders werden Zusammensetzungen enthaltend Komponenten A) und B) bevorzugt, worin Komponente A) die von Formel III abweichenden Reste $X^a$ und die Reste $X^c$ in beiden ortho-Positionen zu jeweils beiden Stickstoffatomen mit $C_1$-$C_6$-Alkyl substituiert sind, die Carbonylgruppen im Rest der Formel III sich in 3,3',4,4'-Position befinden, $\bar{n}$ ein Mittelwert von 1,0 bis 1,5 ist und $Z^a$ und gegebenenfalls $Z^b$ Reste der Formel IV oder IX wie oben definiert sind, insbesondere Reste der Formel IX, worin $R^1$ -CO-, -O- oder $-C(CF_3)_2-$ bedeutet und worin in Komponente B) $Z^d$ und gegebenenfalls $Z^e$ Reste der Formel IV oder IX wie oben definiert sind, insbesondere Reste der Formel IX, worin $R^1$ -O- oder $-C(CF_3)_2-$ ist, $X^j$ ein zweiwertiger aromatischer Diaminrest ist, der in mindestens einer ortho-Position, bevorzugt in beiden ortho-Positionen, zu beiden Stickstoffatomen mit $C_1$-$C_6$Alkyl substituiert ist, worin wenigstens 80 Mol% der Reste $X^j$ und gegebenenfalls $X^k$ mit den von Formel III abweichenden Resten $X^a$ und gegebenenfalls $X^b$ identisch sind.

Ganz besonders bevorzugt werden Zusammensetzungen enthaltend Komponenten A) und B), worin Komponente A) aus 100 Mol% an wiederkehrenden Struktureinheiten der Formel I besteht und Komponente B) aus 100 Mol% an wiederkehrenden Struktureinheiten der Formel XXXI besteht und $X^j$ ein zweiwertiger aromatischer Diaminrest ist, der in beiden ortho-Positionen zu jeweils beiden Stickstoffatomen mit $C_1$-$C_6$Alkyl substituiert ist.

Ebenfalls besonders bevorzugt werden Zusammensetzungen enthaltend Komponenten A') und B), worin Komponente A') aus 10-60 Mol% an wiederkehrenden Struktureinheiten der Formel XXVIII und aus 90-40 Mol% an wiederkehrenden Struktureinheiten der Formel XXIX besteht, worin in Formel XXVIII ein 3,3',4,4'-Thioxanthontetracarbonsäurerest auftritt, $Z^d$ und $Z^e$ Reste der 3,3',4,4'-Benzophenontetracarbonsäure sind und $X^g$ und $X^h$ unabhängig voneinander zweiwertige aromatische Diaminreste sind, die in mindestens einer, bevorzugt beiden, ortho-Position zu beiden Stickstoffatomen mit $C_1$-$C_6$Alkyl substituiert sind, wobei mindestens 60 Mol% der Reste $X^j$ und gegebenenfalls $X^k$ mit den Resten $X^g$ und $X^h$ identisch sind.

Ganz besonders bevorzugt werden Zusammensetzungen aus Komponenten A') und B), worin Komponente B) aus 100 Mol% an wiederkehrenden Struktureinheiten der Formel XXXI besteht und $X^g$ und $X^h$ unabhängig voneinander zweiwertige aromatische Diaminreste sind, die in beiden ortho-Positionen zu jeweils beiden Stickstoffatomen mit $C_1$-$C_6$Alkyl substituiert sind.

Bevorzugt handelt es sich bei den bevorzugten Ausführungsformen betreffend Zusammensetzungen aus A)/B) oder A')/B) um Polyimide mit Diaminresten der oben definierten Formeln XV bis XVIII.

Aus den erfindungsgemässen Copolyimiden oder den Zusammensetzungen aus Komponenten A) und B) oder A') und B) lassen sich strahlungsempfindliche Beschichtungen mit hoher Photoaktivität herstellen.

Die Copolyimide und die Gemische sind in der Regel in einer Vielzahl von inerten organischen Lösungsmitteln unterschiedlicher Polarität löslich und werden bevorzugt in Form ihrer Lösungen eingesetzt.

Geeignete Lösungsmittel sind z.B. polare, aprotische Lösungsmittel, die alleine oder in Mischungen aus mindestens zwei Lösungsmitteln verwendet werden können. Beispiele sind: Ether, wie Dibutylether, Tetrahydrofuran, Dioxan, Ethylenglykol, Dimethylethylenglykol, Dimethyldiethylenglykol, Diethyldiethylenglykol oder Dimethyltriethylenglykol, halogenierte Kohlenwasserstoffe, wie Methylenchlorid, Chloroform, 1,2-Dichlorethan, 1,1,1-Trichlorethan oder 1,1,2,2-Tetrachlorethan, Carbonsäureester und Lactone, wie Essigsäureethylester, Propionsäuremethylester, Benzoesäureethylester, 2-Methoxyethylacetat, $\gamma$-Methoxypropylacetat, $\gamma$-Butyrolacton, o-Valerolacton und Pivalolacton, Carbonsäureamide und Lactame, wie Formamid, Acetamid, N-Methylformamid, N,N-Dimethylformamid, N,N-Diethylformamid, N,N-Dimethylacetamid, N,N-Diethylacetamid, $\gamma$-Butyrolactam, $\epsilon$-Caprolactam, N-Methylpyrrolidon, N-Acetylpyrrolidon, N-Methylcaprolactam, Tetramethylharnstoff oder Hexamethylphosphorsäureamid, Sulfoxide, wie Dimethylsulfoxid, Sulfone wie Dimethylsulfon, Diethylsulfon, Trimethylensulfon oder Tetramethylensulfon und substituierte Benzole, wie Chlorbenzol, o-Dichlorbenzol, Nitrobenzol, Phenole oder Kresole.

Ungelöste Anteile können durch Filtration, bevorzugt durch Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Sensibilisatoren, Antioxidantien, Stabilisatoren, Lichtschutzmittel, Farbstoffe, Pigmente, Haftvermittler und Antihalofarbstoffe, wie sie z.B. in der US-PS 4 349 619 beschrieben sind.

Das Beschichtungsmittel kann mittels üblichen Methoden, wie Tauch-, Streich- und Sprühverfahren, Schleuder-, Kaskadenguss- und Vorhanggussbeschichtung, auf geeignete Substrate bzw. Trägermaterialien aufgebracht werden.
Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$.
Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu 50 $\mu$m und mehr aufweisen.

Schutzfilme aus solchen Polyimiden oder Polyimidgemischen können durch Strahlungseinwirkung weiter modifiziert werden, womit z.B. noch weiter erhöhte Thermostabilitäten erzielbar sind. Ferner besteht die Möglichkeit, diese Polyimide oder Polyimidgemische als photographisches Aufzeichnungsmaterial für Reliefabbildungen einzusetzen. Die Polymerschicht des erfindungsgemässen Materials weist eine für diese Verbindungsklasse hohe Lichtempfindlichkeit auf und sie kann direkt photovernetzt werden. Durch die Direktvernetzung unter Strahlungseinwirkung können Zusätze, wie Sensibilisatoren, vermieden werden und die Schutzschichten, Abbildungen und Filme weisen ausgezeichnete elektrische Eigenschaften auf. Man kann allerdings auch zusätzliche Sensibilisatoren verwenden. Ferner zeichnen sich die Schutzschichten, Abbildungen und Filme durch hohe Haftfestigkeit und thermische, mechanische und chemische Widerstandsfähigkeit aus. Bei thermischen Nachbehandlungen wird nur ein geringer Schwund beobachtet, was in der Anwendung erhebliche Vorteile hat, weil praktische keine Verzerrung abgebildeter Strukturen beobachtet wird bzw. weil keine inneren Spannungen in Ueberzügen und Filmen entstehen.

Das Material ist lagerstabil, aber vorteilhaft vor Lichteinwirkung zu schützen.

Die Herstellung von Schutzfilmen oder Reliefstrukturen erfolgt in der Regel durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Zum Gegenstand der Erfindung zählt auch ein Verfahren zur Herstellung von Schutzfilmen oder von Reliefstrukturen umfassend die Schritte

i) Beschichten eines Trägermaterials mit einem Copolyimid oder einem Polyimidgemisch, wie oben definiert,

ii) Bestrahlen des beschichteten Materials mit einem Muster aktinischer Strahlung, so dass die bestrahlten Stellen besagter Polymerschicht vernetzt werden und

iii) Entwickeln des Systems mit einem geeigneten Entwickler.

Zum Gegenstand der Erfindung zählen ferner die durch Strahlungsvernetzung erhaltenen Schutzüberzüge und Reliefabbildungen.

Die Photostrukturierung bzw. Photovernetzung kann durch aktinische Strahlung hervorgerufen werden, z.B. durch UV-Licht, Röntgenstrahlen, Laserlicht oder Elektronenstrahlen, insbesondere durch UV-Licht bei den Wellenlängen 365 und 405 nm.
Mit den Copolyimiden oder den Polyimidgemischen dieser Erfindung gelingt es, auch auf lichtstreuenden oder lichtreflektierenden Substraten, wie Keramik oder Aluminium, hochaufgelöste Reliefstrukturen zu

erzeugen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten und integrierter Schaltkreise, Relais für die Herstellung von Röntgenmasken, als Lötstopplack, als Dielektrikum für Mehrlagenschaltungen, als Strukturelement für Flüssigkristallanzeigen.

Ein weiterer Gegenstand dieser Erfindung ist die Verwendung der oben definierten Copolyimide oder Polyimidzusammensetzungen zur Herstellung von Isolier-, Passivier- und Schutzschichten und von Reliefabbildungen. Die Schichtdicke der Polymerschicht beträgt für diese Anwendungen bevorzugt 0,5 bis 100 µm, besonders 1 bis 50 µm und insbesondere 1 bis 10 µm.

Die folgenden Beispiele erläutern die Erfindung.

I. Allgemeine Versuchsbedingungen

Die neuen photoempfindlichen Polyimide bzw. die Komponenten der Polyimid-Mischungen, werden nach Verfahren wie in EP-A-132,231 und EP-A-181,837 beschrieben, hergestellt und isoliert.

Photoempfindliche Schichten dieser neuen Polyimidsysteme stellt man durch Schleuderbeschichtung aus Lösung her, wobei man die gebrauchsfertigen Lösungen dadurch gewinnt, dass man die Einzelpolyimide bzw. die Harzmischungen in den Lösungsmitteln 4-Butyrolacton oder N-Methylpyrrolidon bei einem Gesamt-Feststoffgehalt von 5.0-15.0 % löst, und die Lösungen dann einer Druckfiltration durch Filter der Porenweite 0,2-0,8 µm unterzieht.

Zur Bestimmung der Photoempfindlichkeit stellt man hochaufgelöste Reliefstrukturen der Schichtstärke 1,00 ± 0,05 µm auf Siliziumwafern her, wobei eine entsprechende Chrommaske mit Linien bis 1,0 µm benutzt wird, und auch unterschiedliche Teile eines Wafers mit unterschiedlicher Energie belichtet werden.

Nach dem Entwickeln durch Aufsprühen einer geeigneten Entwicklerlösung erhält man Feinstrukturen einer Belichtungsreihe. Die Struktrurbreiten der Linien mit der nominalen Breite von 4 µm werden optisch bestimmt, und die für das Polyimid-System benötigte Belichtungsenergie wird durch Vergleich mit einem Standard-System festgestellt.

Die verwendete Belichtungsmaschine ist eine Masken-Justier- und Belichtungsmaschine des Fabrikates Karl Süss MJB 55, die ihre Leistung im Bereich der Linien 365 nm, 405 nm und 436 nm hat. Die Wafer werden im Vakuum-Kontakt belichtet.

Vor jeder Schleuderbeschichtung wird das Substrat mit einer Lösung des Haftvermittlers 3-Aminopropyltriethoxysilan vorbehandelt.

Zur Beurteilung des Verhaltens auf stark reflektierenden bzw. lichtstreuenden Substraten, werden Schichten der Stärke 2,0-10,0 µm auf 63 x 63 mm grossen Keramiksubstraten hergestellt. Man erzeugt ebenfalls eine Belichtungsreihe von Feinstrukturen, wobei die Beurteilung durch Inspektion im Rasterelektronenmikroskop erfolgt.

Die spektralen Empfindlichkeiten ermittelt man, indem man das Licht der Belichtungsapparatur durch Quecksilberlinien-Interferenzfilter filtriert, und so monochromatische Belichtungen mit den einzelnen Emissionslinien des Quecksilberlampenspektrums durchführt. Die Strahlungsleistungen werden dabei mit einem OAI-Powermeter und den Sonden von 400 bzw. 365 nm gemessen, die Strahlungsleistung des gesamten Quecksilberlampenspektrums wird auf die Sonde von 400 nm bezogen.

Die physikalischen Eigenschaften der einzelnen Polymeren werden durch ihre Glasumwandlungstemperatur ($T_g$) und ihre inhärenten Viskositäten $\eta_{inh}$ (0,5 Gew.% in NMP bei 25 °C) charakterisiert.

II. Einzelbeispiele

Beispiel 1: Ein Photopolyimid 1, enthaltend 90,9 Mol% Benzophenontetracarbonsäuredianhydrid (BTDA) und 9,1 Mol% Thioxanthontetracarbonsäuredianhydrid wird nach folgender Formel hergestellt.

| | |
|---|---|
| Thioxanthontetracarbonsäuredianhydrid (entsprechend EP-A-181,837, Beispiel b) | 0,3523 g = 1 mMol |
| BTDA | 3,2211 g = 10 mMol |
| 1,4-Diamino-2,3,5,6-tetramethylbenzol | 0,9937 g = 6,05 mMol |
| 4,4'-Diamino-3,3'-dimethyl-5,5-diethyl-diphenylmethan | 1,3973 g = 4,95 mMol |

Man lässt zuerst das Thioxanthontetracarbonsäuredianhydrid mit dem Gemisch der Diamine bei 0-5 °C für 30 min reagieren, bis sich eine klare Lösung gebildet hat, und gibt dann das BTDA zu. Nach dem

Imidisieren erhält man ein Polyimid mit den folgenden physikalischen Daten:
$\eta_{inh}$ = 0,88 dl/g
$T_g$ = 369 °C
1 µm starke Schichten dieses Polymeren auf Siliziumwafern erhält man dadurch, dass man (nach Applikation des Haftvermittlers 3-Aninopropyltriethoxysilan) eine gefilterte 9,0 %ige Lösung in 4-Butyrolacton bei 3'700 U/min 25 sec lang aufschleudert, und die Schichten dann 30 min lang bei 80 °C auf einem Hotplate trocknet.

Um nach der Belichtung durch eine Chrommaske hochaufgelöste Feinstrukturen zu entwickeln, sprüht man 31 sec lang Cyclopentanon auf, gefolgt von einem Spülzyklus von 5 sec mit Xylol.

Dabei ist eine Belichtungsenergie von 165 mJ/cm$^2$ notwendig, um gute Strukturen zu erzeugen, wenn man das gesamte Linienspektrum der Belichtungsmaschine (365 nm + 405 nm +436 nm) zur Belichtung verwendet.

Filtert man nur die Emissionslinie von 405 nm aus, so beträgt die benötigte Belichtungsenergie 173 mJ/cm$^2$, monochromatisch gemessen.

Hochaufgelöste Reliefstrukturen auf einem stark reflektierenden und lichtstreuenden Substrat erhält man, wenn man die 9 % Lösung des Polymeren 1 25 sec lang bei 1'350 U/min auf Keramiksubstrate aufschleudert, 30 min bei 80 °C trocknet und dann durch eine Testmaske mit dem Muster USAF 1951 (freistehende Linien) belichtet.

Wenn man mit einer Gesamtenergie (alle Spektrallinien der Belichtungsmaschine) von 141 mJ/cm$^2$ belichtet und dann 50 sec lang durch Aufsprühen von Cyclopentanon in einem Sprühentwickler entwickelt, erhält man trotz rauher Oberflächentopologie hochaufgelöste Reliefstrukturen, wobei auch das Strukturelement 7,4 (2,8 µm breite freistehende Linien) der erhaltenen 2,5 µm starken Bildelemente noch aufgelöst ist.

Beispiel 2: (Polyimid-Mischung)

Ein Polymeres 2, entsprechend EP-A-132,221 hergestellt aus

| | |
|---|---|
| Benzophenontetracarbonsäuredianhydrid | 100 Mol % |
| 1,4-Diamino-2,3,5,6-tetramethylbenzol | 55 Mol % |
| 4,4'-Diamino-3,3'-dimethyl-5,5'-diethyl-diphenylmethan | 45 Mol % |

wird in folgender Weise zusammen mit Polymer 1 zu einem Polyimid-Blend verarbeitet.

| | |
|---|---|
| Polyimid 1: | 0,175 g (30 Gew.-%) $\eta_{inh}$ = 0.88 dl/g; |
| Polyimid 2: | 0,408 g (70 Gew.-%) $\eta_{inh}$ = 0,97 dl/g; |
| 4-Butyrolacton: | 6,276 g. |

Die insgesamt 8,5 %ige Lösung wird bei 3'800 U/min (20 sec) auf Siliziumwafer aufgeschleudert, um Schichten der Stärke 1,0 µm zu erzeugen.

Um gute Feinstrukturen der Breite 4 µm herzustellen, ist eine Belichtungsenergie von 327,5 mJ/cm$^2$ notwendig, wobei man 24 sec mit Cyclopentanon entwickelt. Im Rasterelektronenmikroskop zeigen die Strukturen eine homogene Materialbeschaffenheit.

Beispiele 3-13: Die chemischen Kompositionen der in den Beispielen 3-13 verwendeten Polymeren, sowie deren physikalische Daten sind aus Tabelle 1 ersichtlich. Die Polymeren werden entsprechend EP-A-132,221, EP-A-181,837 und Beispiel 1 hergestellt.

Die Eigenschaften, Prozessdaten sowie Photoempfindlichkeiten der Photopolyimide bzw. Polyimidmischungen der Beispiele 3-13 sind aus Tabelle 2 ersichtlich, zusammen mit den Daten der Beispiele 1-2.

Tabelle 1 Polyimide und Polyimidmischungs-Komponenten

| Polymer Nr. | Dianhydrid 1 (Mol%) | Dianhydrid 2 (Mol%) | Diamin 1 (Mol%) | Diamin 2 | $\eta_{inh}$ [dl/g] | $T_g$ [°C] | löslich in 1) |
|---|---|---|---|---|---|---|---|
| 3 | 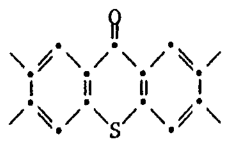 (10) | 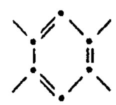 (90) | 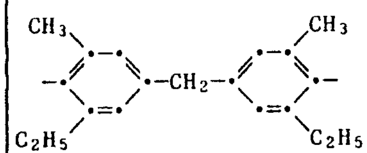 (100) | — | 1,23 | 413 | NMP |
| 4 | — | 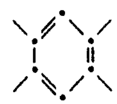 (100) | 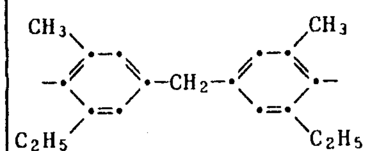 (100) | — | 0,89 | 390 | NMP |
| 5 | 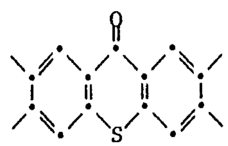 (10) | 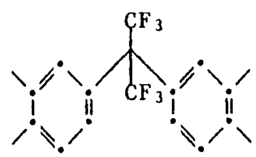 (90) | 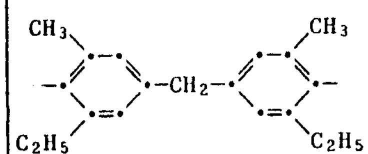 (45) | 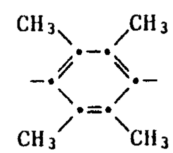 (55) | 1,05 | 376 | GBL |

Tabelle 1 (Fortsetzung)

| Poly-mer Nr. | Dianhydrid 1 (Mol%) | Dianhydrid 2 (Mol%) | Diamin 1 (Mol%) | Diamin 2 (Mol%) | $\eta_{inh}$ [dl/g] | $T_g$ [°C] | lös-lich in 1) |
|---|---|---|---|---|---|---|---|
| 6 | 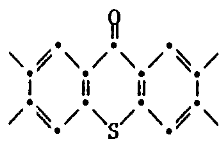 (10) | 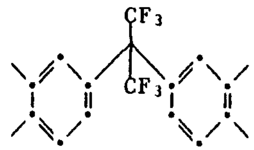 (90) | — | 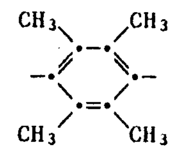 (100) | 0,94 | 448 | GBL |
| 7 | 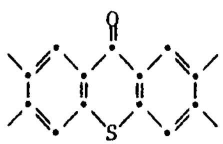 (100) | — | 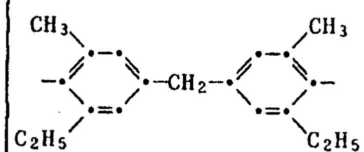 (70) | 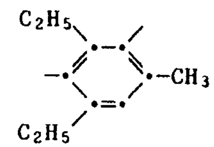 (30) | 0,79 | 403 | NMP |
| 8 | — | 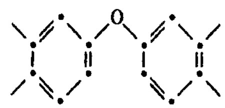 (100) | 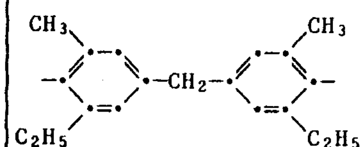 (100) | — | 1,10 | 290 | NMP |

Tabelle 1 (Fortsetzung)

| Poly-mer Nr. | Dianhydrid 1 (Mol%) | Dianhydrid 2 (Mol%) | Diamin 1 (Mol%) | Diamin 2 (Mol%) | $\eta_{inh}$ [dl/g] | $T_g$ [°C] | lös-lich in 1) |
|---|---|---|---|---|---|---|---|
| 9 | 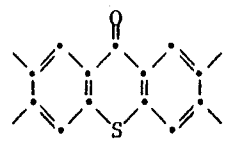 (10) | 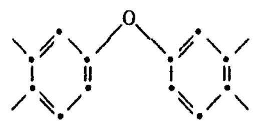 (90) | 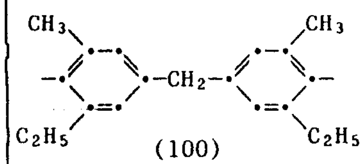 (100) | — | 1,13 | 304 | GBL |
| 10 | 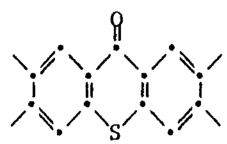 (30) | 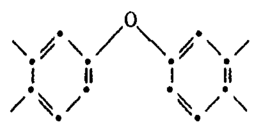 (70) | 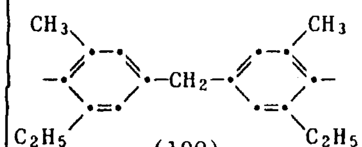 (100) | — | 0,83 | 350 | GBL |
| 11 | 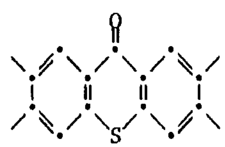 (10) | 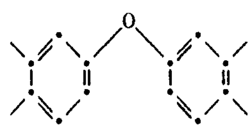 (90) | 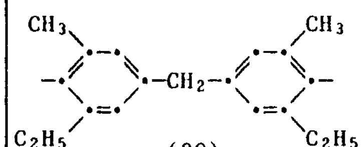 (80) | 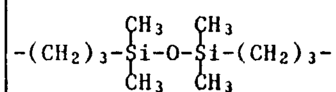 (20) | 0,53 | 232 | GBL |

Tabelle 1 (Fortsetzung)

| Polymer Nr. | Dianhydrid 1 (Mol%) | Dianhydrid 2 (Mol%) | Diamin 1 (Mol%) | Diamin 2 (Mol%) | $\eta_{inh}$ [dl/g] | $T_g$ [°C] | löslich in 1) |
|---|---|---|---|---|---|---|---|
| 12 | — | 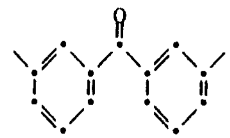 (100) | 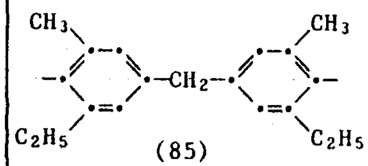 (85) | 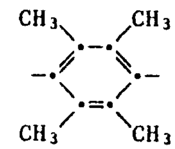 | 1,12 | 316 | GBL |
| 13 | 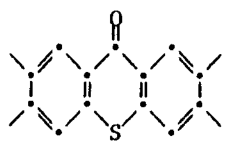 (50) | 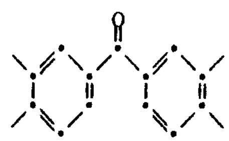 (50) | 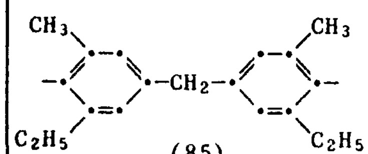 (85) | 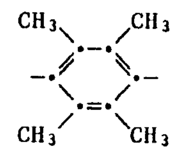 | 1,35 | 406 | GBL |
| 14 | 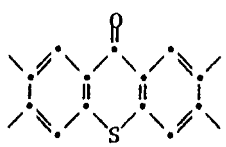 (10) | 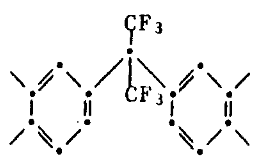 (90) | 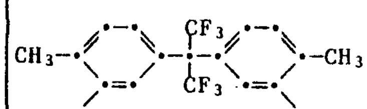 (100) | — | 0,59 | 286 | GBL |

1) NMP: N-Methylpyrrolidon
GBL: 4-Butyrolacton

Tabelle 2 Uebersicht über Beispiele 1-13

| Beispiel Nr. | Polyimid A bzw. A' (Gew.%) | Mischungskomponente B (Gew.%) | Lösungsmittel 1) | Gesamtfeststoffgehalt (Gew.%) | Entwicklerkomposition 2) Lösm. 1 | Lösm. 2 | Entwicklungszeit (sec) | Belichtungsenergie 3) ($mJ/cm^2$) |
|---|---|---|---|---|---|---|---|---|
| 1 | 1 (100) | — | GBL | 9,0 | Cyclopentanon | — | 21 | 165 |
| 2 | 1 (30) | 2 (70) | GBL | 8,5 | Cyclopentanon | — | 24 | 327,5 |
| 3 | 3 (100) | — | NMP | 5,5 | NMP (1) : | Ethanol (0,50) | 18 | 210 |
| 4 | 3 (50) | 4 (50) | NMP | 6,0 | NMP (1) : | Ethanol (0,50) | 15 | 818 |
| 5 | 5 (100) | — | GBL | 7,5 | Cyclopentanon (1) : | Xylol (1,30) | 20 | 68,8 |
| 6 | 6 (100) | — | GBL | 7,5 | Cyclopentanon | — | 20 | 109,5 |
| 7 | 7 (10) | 2 (90) | NMP | 8,5 | NMP (1) : | Xylol (1,25) | 25 | 317 |

Tabelle 2: (Fortsetzung)

| Beispiel Nr. | Polyimid A/bzw. A' (Gew.%) | Mischungskomponente B (Gew.%) | Lösungsmittel 1) | Gesamtfeststoffgehalt (Gew.%) | Entwicklerkomposition 2) Lösm. 1 Lösm. 2 | Entwicklungszeit (sec) | Belichtungsenergie 3) (mJ/cm²) |
|---|---|---|---|---|---|---|---|
| 8 | 9 (100) | — | GBL | 8,2 | GBL(1):Xylol(1,50) | 18 | 35 |
| 9 | 10 (100) | — | GBL | 10,0 | GBL(1):Xylol(1,50) | 18 | 66 |
| 10 | 10 (33,4) | 8 (66,6) | NMP | 8,0 | NMP(1):Xylol(1,60) | 10 | 51 |
| 11 | 11 (100) | — | GBL | 11,0 | Cyclopentanon | 40 | 773 |
| 12 | 13 (12,5) | 12 (87,5) | NMP | 7,0 | NMP(1): Ethanol(0,32) | 60 | 129 |
| 13 | 14 (100) | — | GBL | 9,9 | Propylencarbonat(1): Ethanol(0,67) | 8 | 450 |

1) vgl. Tabelle 1
2) Gewichtsteile
3) Gesamtspektrum (365, 405, 436 nm, Sonde 400 nm)

## Patentansprüche

**1.** Copolyimide aus 100-70 Mol% an wiederkehrenden Struktureinheiten der Formel I und 0-30 Mol% an wiederkehrenden Struktureinheiten der Formel II

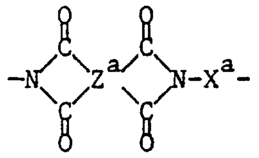 (I), 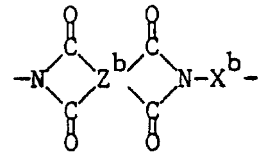 (II),

worin $Z^a$ ein vierwertiger aromatischer Rest einer Tetracarbonsäure ist, der sich von Thioxanthontetracarbonsäure unterscheidet und dessen Carboxylgruppen sich jeweils paarweise in ortho- oder peri-Position zueinander befinden, $X^a$ ein zweiwertiger aromatischer Rest eines Diamins ist, der in mindestens einer ortho-Position zu mindestens einem Stickstoffatom einen Kohlenwassersubstituenten mit wenigstens einem aliphatischen $\alpha$-Wasserstoffatom trägt oder $X^a$ ein Rest der Formel III ist

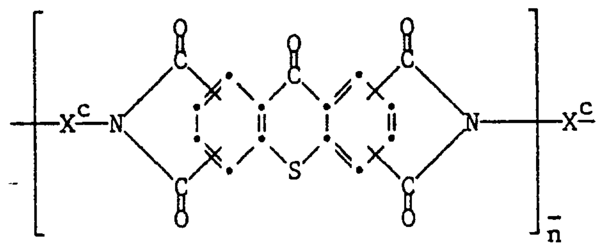 (III),

worin $X^c$ ein zweiwertiger aromatischer Rest eines Diamins ist, der in ortho-Position zu beiden Stickstoffatomen jeweils mindestens einen einwertigen Kohlenwasserstoffsubstituenten mit mindestens einem aliphatischen $\alpha$-Wasserstoffatom trägt, $\bar{n}$ einen Mittelwert von 1,0 bis 2,5 annimmt,
$Z^b$ eine der Bedeutungen von $Z^a$ annimmt und $X^b$ ein aliphatischer, cycloaliphatischer, aromatischer oder araliphatischer Rest eines Diamins ausgenommen eines Restes der Formel III darstellt, mit der Massgabe, dass der Anteil der Reste der Formel III in Formel I so gewählt wird, dass die Menge der Thioxanthontetracarbonsäurereste, bezogen auf die Gesamtmenge der Tetracarbonsäureeinheiten des Copolyimids, zwischen 1 und 30 Mol % beträgt.

**2.** Copolyimide gemäss Anspruch 1, worin $Z^a$ und $Z^b$ Reste der Formeln IV und/oder IX sind

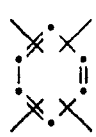 (IV), 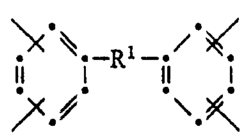 (IX),

worin die freien Bindungen sich jeweils paarweise in ortho-Position zueinander befinden,
$R^1$ eine Gruppe der Formeln -S-, $-SO_2-$, $-NR^2-$, $-SiR^3R^4-$, $-SiR^3R^4-O-SiR^3R^4-$und $-O-R^5-SiR^3R^4-O-SiR^3R^4-R^5-O-$ und insbesondere -CO-, -O-, $-CH_2-$, $-C(CH_3)_2-$ oder $-C(CF_3)_2-$ darstellt, $R^2$ Wasserstoff oder $C_1$-$C_6$Alkyl bedeutet, $R^3$ und $R^4$ unabhängig voneinander $C_1$-$C_6$Alkyl, $C_1$-$C_6$Perfluoralkyl, $C_1$-$C_6$Alkoxy oder $C_1$-$C_6$Perfluoralkoxy sind und $R^5$ Alkylen ist.

**3.** Copolyimide gemäss Anspruch 1, worin der Anteil der Thioxanthonreste, bezogen auf die Gesamtmenge der Tetracarbonsäureeinheiten des Copolyimids, 5,0 bis 15 Mol% beträgt.

**4.** Copolyimide gemäss Anspruch 1, worin $\bar{n}$ einen Mittelwert von 1,0 bis 1,5 annimmt.

**5.** Copolyimide gemäss Anspruch 1, worin alle Reste $X^a$, die keine Reste der Formel III sind, zweiwertige Reste eines aromatischen Diamins sind, das in ortho-Position zu beiden Stickstoffatomen, insbesondere in beiden ortho-Positionen zu beiden Stickstoffatomen, jeweils einen einwertigen Kohlenwasserstoffrest mit aliphatischen $\alpha$-Wasserstoffatomen trägt und worin die Reste $X^c$ in Formel III sich von aromatischen Diaminen ableiten, in denen beide ortho-Positionen beider Stickstoffatome jeweils einwertige Kohlenwasserstoffreste mit aliphatischen $\alpha$-Wasserstoffatomen tragen, und worin $X^b$, falls vorhanden, insbesondere ein siloxan-modifizierter Alkylenrest ist.

6. Copolyimide gemäss Anspruch 5, worin $X^c$ und alle Reste $X^a$, die keine Reste der Formel III sind, Gruppen der Formeln XV bis XVIII sind

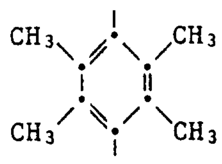 (XV), 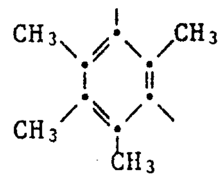 (XVI),

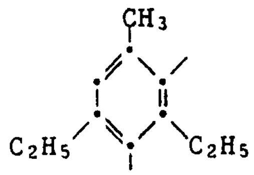 (XVII), 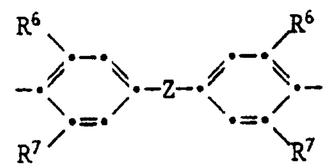 (XVIII),

worin Z eine direkte Bindung ist oder -O-, $-CH_2-$ oder $-C(CF_3)_2-$bedeutet, und $R^6$ und $R^7$ unabhängig voneinander $C_1$-$C_6$ Alkyl sind.

7. Copolyimide bestehend aus wiederkehrenden Struktureinheiten der Formel I gemäss Anspruch 1, worin alle Reste $X^c$ und die von Formel III abweichenden Reste $X^a$ sich von aromatischen Diaminen ableiten, in denen beide ortho-Positionen beider Stickstoffatome jeweils einwertige Kohlenwasserstoffreste mit aliphatischen α-Wasserstoffatomen, insbesondere $C_1$-$C_6$-Alkylgruppen, tragen.

8. Verfahren zur Herstellung von Copolyimiden gemäss Anspruch 1 umfassend die Herstellung eines Vorkondensats der Formel XXV und gegebenenfalls dessen Auftrennung und Isolierung

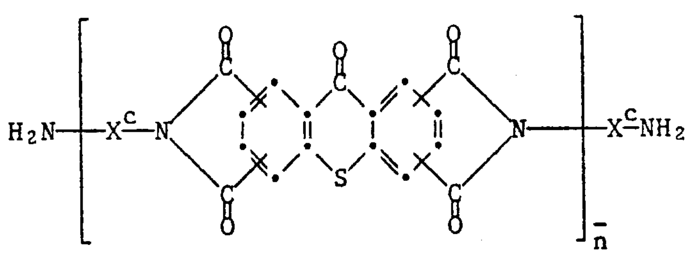 (XXV),

durch Polykondensation einer Verbindung der Formel XX oder einer ihrer polyimidbildenden Derivate mit einem Ueberschuss an Diamin der Formel XXIII in an sich bekannter Weise

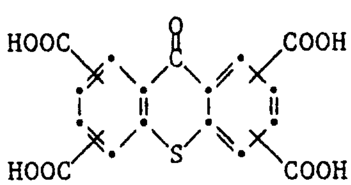 (XX), $H_2N-X^c-NH_2$ (XXIII),

und anschliessender Polykondensation besagten Vorkondensats mit den restlichen Tetracarbonsäure- und gegebenenfalls Diaminkomponenten der Formeln XIX, XXI, XXVI und XXVII in an sich bekannter Weise

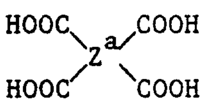 (XIX), 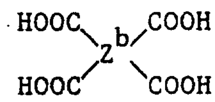 (XXI),

$H_2N\text{-}X^f\text{-}NH_2$ (XXVI), $H_2N\text{-}X^b\text{-}NH_2$ (XXVII);

worin $\bar{n}$, $Z^a$, $Z^b$, $X^b$ und $X^c$ die in Anspruch 1 definierte Bedeutung besitzen und $X^f$ eine der für $X^a$ in Anspruch 1 definierten Bedeutungen mit Ausnahme der Formel III besitzt.

**9.** Zusammensetzungen enthaltend als Polyimidkomponenten im wesentlichen

A) ein Copolyimid oder eine Mischung von Copolyimiden aus 100-70 Mol% an wiederkehrenden Struktureinheiten der Formel I und 0-30 Mol% an wiederkehrenden Struktureinheiten der Formel II gemäss Anspruch 1, wobei die Gesamtmenge an Thioxanthonresten in Komponente A), bezogen auf die Gesamtmenge aller Tetracarbonsäurereste dieser Komponente, 2,0 bis 40 Mol% beträgt, oder

A') ein Polyimid oder eine Mischung von Polyimiden aus 100-20 Mol% an wiederkehrenden Struktureinheiten der Formel XXVIII, 0-80 Mol% an wiederkehrenden Struktureinheiten der Formel XXIX und 0-30 Mol% an wiederkehrenden Struktureinheiten der Formel XXX

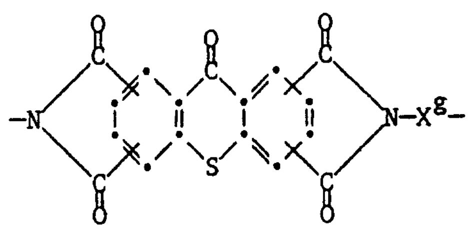 (XXVIII),

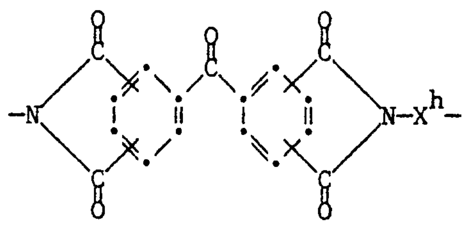 (XXIX), 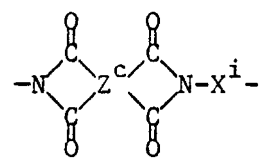 (XXX),

worin $Z^c$ eine der für $Z^a$ definierten Bedeutungen annehmen kann und $X^g$, $X^h$ und $X^i$ unabhängig voneinander eine der für $X^c$ definierten Bedeutungen annehmen können, und

B) ein Polyimid oder ein Gemisch von Polyimiden aus 100-80 Mol% an wiederkehrenden Struktureinheiten der Formel XXXI und aus 0-20 Mol% an wiederkehrenden Struktureinheiten der Formel XXXII

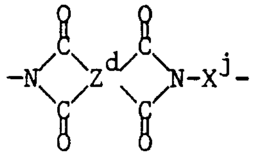 (XXXI), 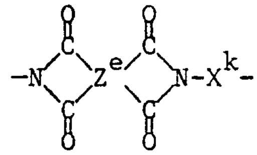 (XXXII),

worin $Z^d$ und $Z^e$ unabhängig voneinander eine der für $Z^a$ definierten Bedeutungen annehmen können, $X^j$ eine der für $X^a$ definierten Bedeutungen mit Ausnahme der Formel III annehmen kann und $X^k$ eine der für $X^b$ definierten Bedeutungen annehmen kann,

wobei im Falle der A)/B) Mischungen gilt, dass wenigstens 70 Mol% der Reste $Z^d$ und gegebenenfalls $Z^e$ in Komponenten B), bezogen auf die Gesamtmenge dieser Reste, mit den Resten $Z^a$ und gegebenenfalls $Z^b$ in Komponente A) identisch sein müssen und wenigstens 70 Mol% der Reste $X^j$ und gegebenenfalls $X^k$ in Komponente B), bezogen auf die Gesamtmenge dieser Reste, mit den von

Formel III abweichenden Resten $X^a$ und gegebenenfalls den Resten $X^b$ in Komponente A) identisch sein müssen,
oder wobei mindestens 40 Mol% der Reste $X^j$ und gegebenenfalls $X^k$ in Komponente B), bezogen auf die Gesamtmenge dieser Reste, mit den Resten $X^g$ und gegebenenfalls $X^h$ und $X^i$ in Komponente A') identisch sein müssen, mit der Massgabe, dass
die Kombination A')/B) für den Fall möglich ist, dass 80-100 Mol% der Tetracarbonsäurereste der Komponente B) sich von Benzophenontetracarbonsäure ableiten, und dass in allen anderen Fällen die Kombinationen A)/B) möglich sind,
und dass bei allen Kombinationen A)/B) und A')/B) die Menge der Komponenten A) oder A') so gewählt wird, dass die Menge der Thioxanthontetracarbonsäurereste, bezogen auf die Gesamtmenge der Tetracarbonsäurereste in der Polyimidmischung, zwischen 1,0 und 30 Mol%, insbesondere zwischen 1,0 und 20 Mol%, liegt.

**10.** Zusammensetzungen enthaltend Komponenten A) und B) gemäss Anspruch 9, worin in Komponente A) die von Formel III abweichenden Reste $X^a$ und die Reste $X^c$ in beiden ortho-Positionen zu jeweils beiden Stickstoffatomen mit $C_1$-$C_6$Alkyl substituiert sind, die Carbonylgruppen im Rest der Formel III sich in 3,3',4,4'-Position befinden, $\bar{n}$ ein Mittelwert von 1,0 bis 1,5 ist und $Z^a$ und gegebenenfalls $Z^b$ Reste der Formel IV oder IX gemäss Anspruch 2 sind, insbesondere Reste der Formel IX, worin $R^1$ -CO-, -O- oder -$C(CF_3)_2$- bedeutet, und worin in Komponente B) $Z^d$ und gegebenenfalls $Z^e$ Reste der Formel IV oder IX gemäss Anspruch 2 sind, insbesondere Reste der Formel IX, worin $R^1$ -O- oder -C-$(CF_3)_2$- ist, $X^j$ ein zweiwertiger aromatischer Diaminrest ist, der in mindestens einer ortho-Position zu beiden Stickstoffatomen mit $C_1$-$C_6$Alkyl substituiert ist, worin wenigstens 80 Mol% der Reste $Z^d$ und $Z^e$ mit den Resten $Z^a$ und $Z^b$ identisch sind und worin wenigstens 80 Mol% der Reste $X^j$ und gegebenenfalls $X^k$ mit den von Formel III abweichenden Resten $X^a$ und gegebenenfalls $X^b$ identisch sind.

**11.** Zusammensetzungen gemäss Anspruch 10, worin Komponente A) aus 100 Mol% an wiederkehrenden Struktureinheiten der Formel I besteht und Komponente B) aus 100 Mol% an wiederkehrenden Struktureinheiten der Formel XXXI besteht und $X^j$ ein zweiwertiger aromatischer Diaminrest ist, der in beiden ortho-Positionen zu jeweils beiden Stickstoffatomen mit $C_1$-$C_6$Alkyl substituiert ist.

**12.** Zusammensetzungen enthaltend Komponenten A') und B) gemäss Anspruch 9, worin Komponente A') aus 10-60 Mol% an wiederkehrenden Struktureinheiten der Formel XXVIII und aus 90-40 Mol% an wiederkehrenden Struktureinheiten der Formel XXIX besteht, worin in Formel XXVIII ein 3,3',4,4'-Thioxanthontetracarbonsäurerest auftritt, $Z^d$ und $Z^e$ Reste der 3,3',4,4'-Benzophenontetracarbonsäure sind und $X^g$ und $X^h$ unabhängig voneinander zweiwertige aromatische Diaminreste sind, die in mindestens einer ortho-Position zu beiden Stickstoffatomen mit $C_1$-$C_6$Alkyl substituiert sind, wobei mindestens 60 Mol% der Reste $X^j$ und gegebenenfalls $X^k$ mit den Resten $X^g$ und $X^h$ identisch sind.

**13.** Zusammensetzungen gemäss Anspruch 12, worin Komponente B) aus 100 Mol% an wiederkehrenden Struktureinheiten der Formel XXXI besteht und $X^g$ und $X^h$ unabhängig voneinander zweiwertige aromatische Diaminreste sind, die in beiden ortho-Positionen zu jeweils beiden Stickstoffatomen mit $C_1$-$C_6$Alkyl substituiert sind.

**14.** Verfahren zur Herstellung von Schutzfilmen oder von Reliefstrukturen umfassend die Schritte
i) Beschichten eines Trägermaterials mit einem Copolyimid gemäss Anspruch 1 oder mit einer Zusammensetzung von Polyimiden gemäss Anspruch 9,
ii) Bestrahlen des beschichteten Materials mit einem Muster aktinischer Strahlung, so dass die bestrahlten Stellen besagter Polymerschicht vernetzt werden und
iii) Entwickeln des Systems mit einem geeigneten Entwickler.

**15.** Verwendung der Copolyimide gemäss Anspruch 1 oder der Polyimidzusammensetzungen gemäss Anspruch 9 zur Herstellung von Isolier-, Passivier- und Schutzschichten und von Reliefabbildungen.

## Claims

**1.** A copolyimide comprising 100-70 mol % of recurring structural units of the formula I and 0-30 mol % of recurring structural units of the formula II

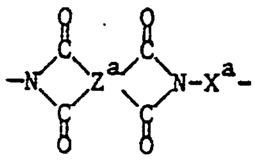 (I), 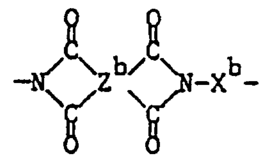 (II),

in which $Z^a$ is a tetravalent aromatic tetracarboxylic acid radical other than that of thioxanthonetetracarboxylic acid, the carboxyl groups thereof in each case being located in pairs in the ortho-position or peri-position relative to one another, and $X^a$ is a divalent aromatic diamine radical which, in at least one ortho-position relative to at least one nitrogen atom, carries a hydrocarbon substituent having at least one aliphatic $\alpha$-hydrogen atom or $X^a$ is a radical of the formula III

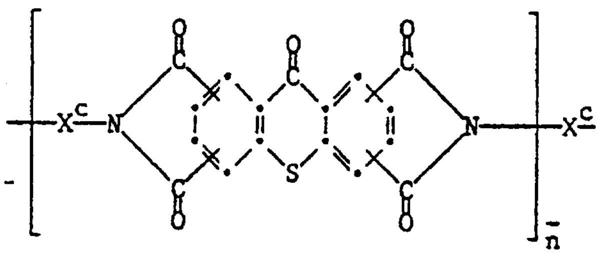 (III),

in which $X^c$ is a divalent aromatic diamine radical which, in ortho-position relative to the two nitrogen atoms, carries in each case at least one monovalent hydrocarbon substituent having at least one aliphatic $\alpha$-hydrogen atom, and $\bar{n}$ assumes an average value of 1.0 to 2.5, $Z^b$ is as defined for $Z^a$ and $X^b$ is an aliphatic, cycloaliphatic, aromatic or araliphatic diamine radical, excluding a radical of the formula III, with the proviso that the proportion of radicals of the formula III in formula I is selected such that the quantity of thioxanthonetetracarboxylic acid radicals, relative to the total quantity of tetracarboxylic acid units in the copolyimide, is between 1 and 30 mol %.

2. A copolyimide according to claim 1, wherein $Z^a$ and $Z^b$ are radicals of the formulae IV and/or IX

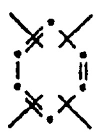 (IV), 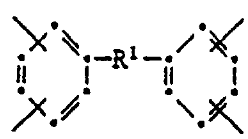 (IX),

in which the free bonds are in each case located in pairs in the ortho-position relative to one another,
$R^1$ is a group of the formulae -S-,
$-SO_2-$, $-NR^2-$, $-SiR^3R^4-$, $-SiR^3R^4-O-SiR^3R^4-$, $-O-R^5-SiR^3R^4-O-SiR^3R^4-R^5-O-$, and especially -CO-, -O-, $-CH_2-$, $-C(CH_3)_2-$ or $-C(CF_3)_2-$,
$R^2$ is hydrogen or
$C_1$-$C_6$alkyl, $R^3$ and $R^4$ independently of one another are $C_1$-$C_6$alkyl,
$C_1$-$C_6$perfluoroalkyl, $C_1$-$C_6$alkoxy or $C_1$-$C_6$perfluoroalkoxy and $R^5$ is alkylene.

3. A copolyimide according to claim 1, wherein the proportion of thioxanthone radicals is 5.0 to 15 mol %, relative to the total quantity of tetracarboxylic acid units in the copolyimide.

4. A copolyimide according to claim 1, wherein $\bar{n}$ assumes an average value from 1.0 to 1.5.

5. A copolyimide according to claim 1, wherein all the radicals $X^a$ other than those of the formula III are divalent radicals of an aromatic diamine which carries in each case a monovalent hydrocarbon radical having aliphatic $\alpha$-hydrogen atoms in the ortho-position relative to the two nitrogen atoms, especially in each of the two ortho-positions relative to both nitrogen atoms, and in which the radicals $X^c$ in formula

III are derived from aromatic diamines in which each of the two ortho-positions relative to both nitrogen atoms carries monovalent hydrocarbon radicals having aliphatic α-hydrogen atoms, and in which $X^b$, if present, is in particular a siloxane-modified alkylene radical.

**6.** A copolyimide according to claim 5, wherein $X^c$ and all the radicals $X^a$ other than those of the formula III are groups of the formulae XV to XVIII

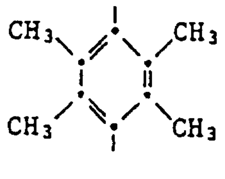 (XV),

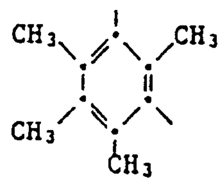 (XVI),

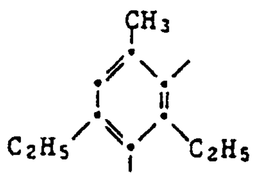 (XVII),

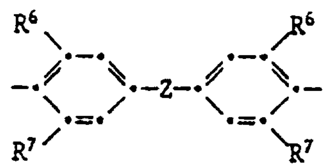

in which Z is a direct bond or -O-, $-CH_2-$ or $-C(CF_3)_2-$, and $R^6$ and $R^7$ independently of one another are $C_1$-$C_6$ alkyl.

**7.** A copolyimide consisting of recurring structural units of the formula I according to claim 1, wherein all the radicals $X^c$ and the radicals $X^a$ other than those of the formula III are derived from aromatic diamines in which both ortho-positions relative to the two nitrogen atoms carry in each case monovalent hydrocarbon radicals having aliphatic α-hydrogen atoms, especially $C_1$-$C_6$ alkyl groups.

**8.** A process for the preparation of a copolyimide according to claim 1 comprising the preparation of a precondensate of the formula XXV and, if desired, separating the latter into its components which are isolated

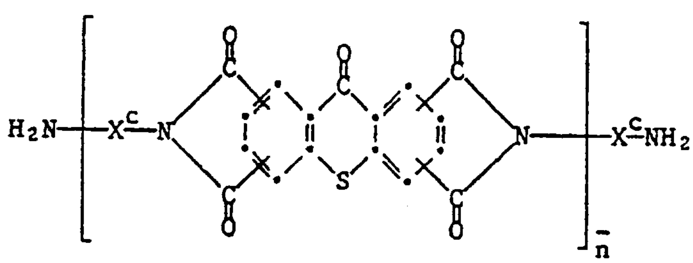 (XXV),

by polycondensing a compound of the formula XX or one of its polyimide- forming derivatives with an excess of a diamine of the formula XXIII in a manner known per se

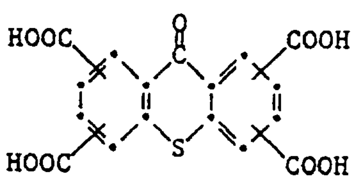 (XX), $H_2N-X^C-NH_2$ (XXIII),

and subsequently polycondensing said precondensate with the remaining tetracarboxylic acid components and, if appropriate, diamine components of the formulae XIX, XXI, XXVI and XXVII in a manner known per se

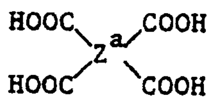 (XIX), 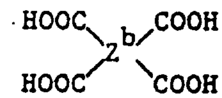 (XXI),

$H_2N-X^f-NH_2$ (XXVI), $H_2N-X^b-NH_2$ (XXVII);

in which $\bar{n}$, $Z^a$, $Z^b$, $X^b$ and $X^c$ are as defined in claim 1 and $X^f$ has one of the meanings defined in claim 1 for $X^a$ with the exception of the formula III.

**9.** A composition containing, as the polyimide components, essentially:

A) a copolyimide or a mixture of copolyimides consisting of 100-70 mol % of recurring structural units of the formula I and 0-30 mol % of recurring structural units of the formula II according to claim 1, the total quantity of thioxanthone radicals in component A), relative to the total quantity of all tetracarboxylic acid radicals in this component, being 2.0 to 40 mol %, or

A') a polyimide or a mixture of polyimides consisting of 100-20 mol % of recurring structural units of the formula XXVIII, 0-80 mol % of recurring structural units of the formula XXIX and 0-30 mol % of recurring structural units of the formula XXX

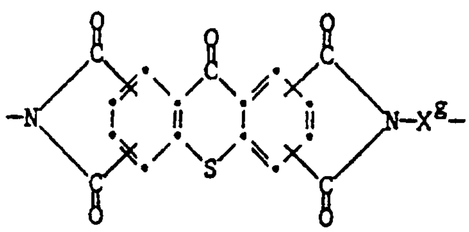 (XXVIII),

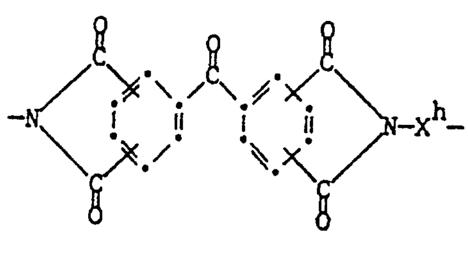 (XXIX), 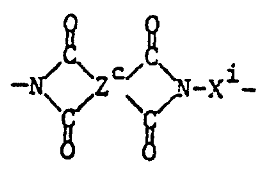 (XXX),

in which $Z^c$ can assume one of the meanings defined for $Z^a$ and $X^g$, $X^h$ and $X^i$ independently of one another can assume one of the meanings defined for $X^c$, and

B) a polyimide or a mixture of polyimides consisting of 100-80 mol % of recurring structural units of the formula XXXI and of 0-20 mol % of recurring structural units of the formula XXXII

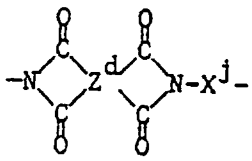 (XXXI), 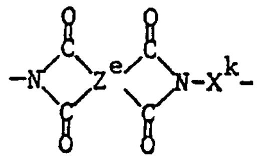 (XXXII),

in which $Z^d$ and $Z^e$ independently of one another can assume one of the meanings defined for $Z^a$, $X^j$ can assume one of the meanings defined for $X^a$ with the exception of the formula III and $X^k$ can assume one of the meanings defined for $X^b$,
it being necessary in the case of the A)/B) mixtures that at least 70 mol % of the radicals $Z^d$ and, if appropriate, $Z^e$ in component B), relative to the total quantity of these radicals, are identical to the radicals $Z^a$ and, if appropriate, $Z^b$ in component A) and at least 70 mol % of the radicals $X^j$ and, if appropriate, $X^k$ in component B), relative to the total quantity of these radicals are identical to the radicals $X^a$ other than those of the formula III and, if appropriate, to the radicals $X^b$ in component A),
or it being necessary that at least 40 mol % of the radicals $X^j$ and, if appropriate, $X^k$ in component B), relative to the total quantity of these radicals, are identical to the radicals $X^g$ and, if appropriate, $X^h$ and $X^i$ in component A'), with the proviso that
the combination A')/B) is possible in the case where 80-100 mol % of the tetracarboxylic acid radicals of component B) are derived from benzophenonetetracarboxylic acid and that the combinations A)/B) are possible in all other cases, and that in all combinations A)/B) and A')/B) the quantity of the components A) or A') is selected such that the quantity of thioxanthonetetracarboxylic acid radicals, relative to the total quantity of the tetracarboxylic acid radicals in the polyimide mixture, is between 1.0 and 30 mol %, especially between 1.0 and 20 mol %.

**10.** A composition containing components A) and B) according to claim 9, wherein, in component A), the radicals $X^a$ other than those of the formula III and the radicals $X^c$ are substituted by $C_1$-$C_6$alkyl in each of the two ortho-positions relative to both nitrogen atoms, the carbonyl groups in the radical of the formula III are in the 3,3',4,4'-positions, $\bar{n}$ is an average value from 1.0 to 1.5 and $Z^a$ and, if appropriate, $Z^b$ are radicals of the formula IV or IX according to claim 2, especially radicals of the formula IX in which $R^1$ is -CO-, -O- or $-C(CF_3)_2-$ and wherein, in component B), $Z^d$ and, if appropriate, $Z^e$ are radicals of the formula IV or IX according to claim 2, especially radicals of the formula IX in which $R^1$ is -O- or $-C(CF_3)_2-$, and $X^j$ is a divalent aromatic diamine radical which is substituted by $C_1$-$C_6$alkyl in at least one ortho-position relative to both nitrogen atoms, at least 80 mol % of the radicals $Z^d$ and $Z^e$ being identical to the radicals $Z^a$ and $Z^b$, and at least 80 mol % of the radicals $X^j$ and, if appropriate, $X^k$ being identical to the radicals $X^a$ other than those of the formula III and, if appropriate, to the radicals $X^b$.

**11.** A composition according to claim 10, wherein component A) consists of 100 mol % of recurring structural units of the formula I and component B) consists of 100 mol % of recurring structural units of the formula XXXI and $X^j$ is a divalent aromatic diamine radical which is substituted by $C_1$-$C_6$alkyl in both ortho-positions relative to each of the two nitrogen atoms.

**12.** A composition containing components A') and B) according to claim 9, wherein component A') consists of 10-60 mol % of recurring structural units of the formula XXVIII and of 90-40 mol % of recurring structural units of the formula XXIX, a 3,3',4,4'-thioxanthonetetracarboxylic acid radical being present in the formula XXVIII, $Z^d$ and $Z^e$ are radicals of 3,3',4,4'-benzophenonetetracarboxylic acid and $X^g$ and $X^h$ independently of one another are divalent aromatic diamine radicals which are substituted by $C_1$-$C_6$alkyl in at least one ortho-position relative to both nitrogen atoms, at least 60 mol % of the radicals $X^j$ and, if appropriate, $X^k$ being identical to the radicals $X^g$ and $X^h$.

**13.** A composition according to claim 12, wherein component B) consists of 100 mol % of recurring structural units of the formula XXXI and $X^g$ and $X^h$ independently of one another are divalent aromatic diamine radicals which are substituted by $C_1$-$C_6$alkyl in both ortho-positions relative to each of the two nitrogen atoms.

**14.** A process for the production of protective films or of relief structures, comprising the steps of:
i) coating a carrier material with a copolyimide according to claim 1 or with a composition of polyimides according to claim 9,

ii) irradiating the coated material with a pattern of actinic radiation, so that the irradiated areas of said polymer layer are crosslinked, and

iii) developing the system with a suitable developer.

**15.** Use of a copolyimide according to claim 1 or of a polyimide composition according to claim 9 for the production of insulating, passivating and protective layers and of relief images.

## Revendications

**1.** Copolyimides constitués de 100 à 70 moles % d'unités structurales répétitives de formule I et 0 à 30 moles % d'unités structurales répétitives de formule II.

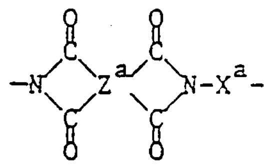 (I), 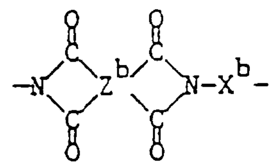 (II),

où $Z^a$ représente un radical aromatique quadrivalent d'un acide tétracarboxylique, qui se différencie de l'acide thioxanthone-tétracarboxylique et dont les groupes carboxyle sont chaque fois par paires dans la position ortho ou dans la position para les uns des autres, $X^a$ est un radical aromatique bivalent d'une diamine, ce radical comportant, dans au moins une position ortho par rapport à au moins un atome d'azote, un substituant hydrocarboné ayant au moins un atome d'hydrogène aliphatique en $\alpha$, ou $X^a$ est un radical de formule III

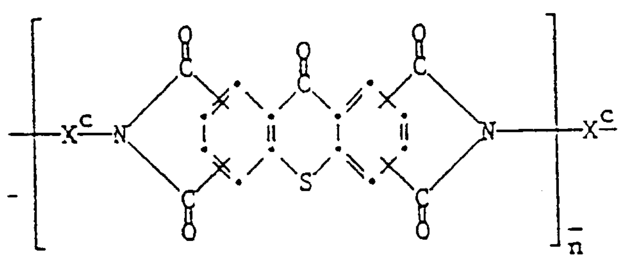 (III),

où $X^c$ est un radical aromatique bivalent d'une diamine, ce radical comportant, en position ortho par rapport aux deux atomes d'azote, chaque fois au moins un substituant hydrocarboné monovalent ayant au moins un atome d'hydrogène aliphatique en $\alpha$, n a une valeur moyenne de 1,0 à 2,5, $Z^b$ a une des significations de $Z^a$, et $X^b$ est un radical aliphatique, cycloaliphatique, aromatique ou araliphatique, d'une diamine, à l'exception d'un radical de formule III, à la condition que la teneur des radicaux de formule III dans la formule I soit choisie de telle sorte que la quantité de radicaux de l'acide thioxanthone-tétracarboxylique, rapportée à la quantité totale d'unités d'acides tétracarboxyliques du copolyimide, ait une valeur entre 1 et 30 moles %.

**2.** Copolyimides selon la revendication 1, où $Z^a$ et $Z^b$ sont des radicaux des formules IV et/ou IX

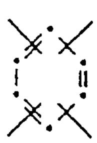 (IV), 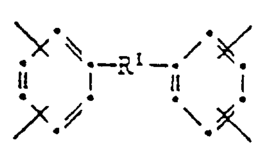 (IX),

où les liaisons libres se trouvent chaque fois par paires en position ortho, les unes par rapport aux autres,

$R^1$ représente un groupe des formules, -S-, $-SO_2-$, $-NR^2-$, $-SiR^3R^4-$, $-SiR^3R^4-O-SiR^3R^4-$ et $-O-R^5-SiR^3R^4-O-SiR^3R^4-R^5-O-$et en particulier -CO-, -O-, $-CH_2-$, $-C(CH_3)_2-$ ou $-C(CF_3)_2$, $R^2$ représente l'hydrogène ou un alkyle en $C_1$-$C_6$, $R^3$ et $R^4$ représentent, indépendamment l'un de l'autre, un alkyle en $C_1$-$C_6$, un perfluoro- alkyle en $C_1$-$C_6$, un alcoxy en $C_1$-$C_6$ ou un perfluoroalcoxy en $C_1$-$C_6$, et $R^5$ représente un alkylène.

**3.** Copolyimides selon la revendication 1, où la teneur en radicaux de thioxanthone, rapportée à la quantité totale d'unités d'acides tétracarboxyliques du copolyimide est de 5,0 à 15 moles %.

**4.** Copolyimides selon la revendication 1, où $\bar{n}$ a une valeur moyenne de 1,0 à 1,5.

**5.** Copolyimides selon la revendication 1, où tous les radicaux $X^a$, qui ne sont aucun des radicaux de formule III, sont des radicaux bivalents d'une diamine aromatique, qui comportent en position ortho, en particulier dans les deux positions ortho par rapport aux deux atomes d'azote, chaque fois au moins un radical hydrocarboné monovalent avec des atomes d'hydrogène aliphatique en $\alpha$, et où les radicaux $X^c$ dans la formule III dérivent de diamines aromatiques, dans lesquels les deux positions ortho des deux atomes d'azote portent chaque fois des restes hydrocarbonés monovalents ayant des atomes d'hydrogène aliphatique en $\alpha$, et où $X^b$, s'il existe, est en particulier un radical alkylène modifié par un siloxane.

**6.** Copolyimides selon la revendication 5, où $X^c$ et tous les radicaux $X^a$, qui ne sont aucun des radicaux de formule III, sont des groupes des formules XV à XVIII

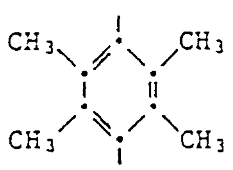 (XV), 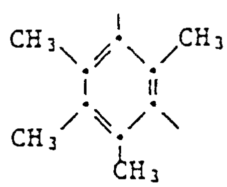 (XVI),

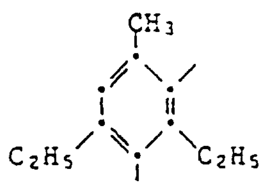 (XVII), 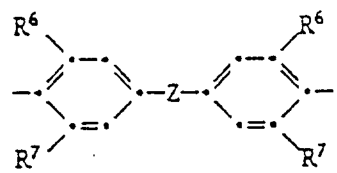 (XVIII),

où Z représente une liaison directe ou -O-, $-CH_2-$ ou $-C(CF_3)_2-$, et $R^6$ et $R^7$, indépendamment l'un de l'autre, représentent un alkyle en $C_1$-$C_6$.

**7.** Copolyimides constitués d'unités structurales répétitives de formule I selon la revendication 1, où tous les radicaux $X^c$ et les radicaux $X^a$ qui se différencient de la formule III dérivent de diamines aromatiques, dans lesquelles les deux positions en ortho des deux atomes d'azote comportent chaque fois des radicaux hydrocarbonés monovalents avec des atomes d'hydrogène aliphatique en $\alpha$, en particulier des groupes alkyles en $C_1$-$C_6$.

**8.** Procédé pour préparer des copolyimides selon la revendication 1, comportant la préparation d'un précondensat de formule XXV et éventuellement sa séparation et son isolation

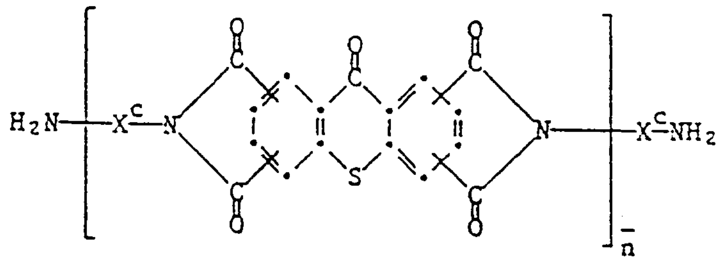 (XXV),

par polycondensation d'un composé de formule XX ou d'un de ses dérivés formant un polyimide avec un excès de diamine de formule XXIII de façon connue en soi

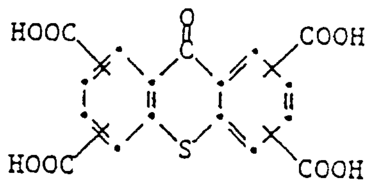 (XX), $H_2N\text{-}X^c\text{-}NH_2$ (XXIII),

et ensuite polycondensation dudit précondensat avec les composants restants d'acide tétracarboxylique et éventuellement de diamine des formules XIX, XXI, XXVI et XXVII de façon connue en soi

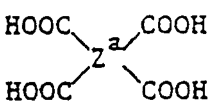 (XIX), 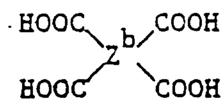 (XXI),

$H_2N\text{-}X^f\text{-}NH_2$ (XXVI), $H_2N\text{-}X^b\text{-}NH_2$ (XXVII);

où $\bar{n}$, $Z^a$, $Z^b$, $X^b$ et $X^c$ ont la signification donnée dans la revendication 1 et $X^f$ a une des significations données dans la revendication 1 pour $X^a$ à l'exception de la formule III.

**9.** Compositions contenant comme composants de polyimide essentiellement

A) un copolyimide ou un mélange de copolyimides constitué de 100-70 moles % d'unités structurales répétitives de formule I, et de 0-30 moles % d'unités structurales répétitives de formule II selon la revendication 1, où la quantité totale de radicaux thioxanthone dans le composant A), rapportée à la quantité totale de tous les radicaux d'acides tétracarboxyliques de ce composant, est de 2,0 à 40 moles %, ou

A') un polyimide ou un mélange de polyimides constitué de 100-20 moles % d'unités structurales répétitives de formule XXVIII, 0-80 moles % d'unités structurales répétitives de formule XXIX et 0-30 moles % d'unités structurales répétitives de formule XXX

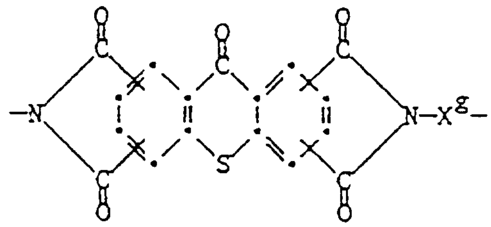 (XXVIII),

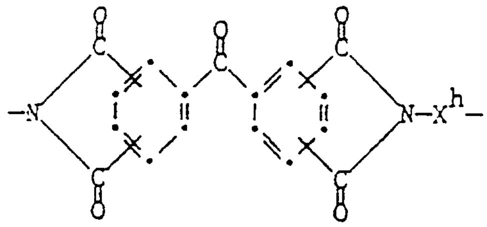 (XXIX), 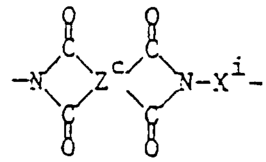 (XXX),

où $Z^c$ peut prendre une des significations définies pour $Z^a$ et $X^g$, $X^h$ et $X^i$, indépendamment les uns des autres, peuvent prendre une des significations définies pour $X^c$, et
B) un polyimide ou un mélange de polyimides constitué de 100-80 moles % d'unités structurales répétitives de formule XXXI et de 0-20 moles % d'unités structurales répétitives de formule XXXII

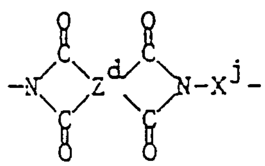 (XXXI), 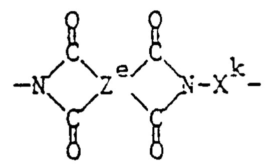 (XXXII),

où $Z^d$ et $Z^e$, indépendamment l'un de l'autre, peuvent prendre une des significations définies pour $Z^a$, $X^j$ peut prendre une des significations définies pour $X^a$, à l'exception de la formule III, et $X^k$ peut prendre une des significations définies pour $X^b$,
de telle sorte que, dans le cas des mélanges A)/B), au moins 70 moles % des radicaux $Z^d$ et éventuellement $Z^e$ dans le composant B), rapportés à la quantité totale de ces radicaux, soient nécessairement identiques aux radicaux $Z^a$ et éventuellement $Z^b$ dans le composant A), et au moins 70 moles % des radicaux $X^j$ et éventuellement $X^k$ dans le composant B), rapportés à la quantité totale de ces radicaux, soient nécessairement identiques aux radicaux $X^a$ qui se différencient de la formule III, et éventuellement des radicaux $X^b$ dans le composant A)
ou de telle sorte qu'au moins 40 moles % des radicaux $X^j$ et éventuellement $X^k$ dans le composant B), rapportés à la quantité totale de ces radicaux, soient nécessairement identiques aux radicaux $X^g$ et éventuellement $X^h$ et $X^i$ dans le composant A'), à la condition que
la combinaison A')/B) soit alors possible, que 80-100 moles % des radicaux d'acides tétracarboxyliques du composant B) dérivent de l'acide benzophénone-tétracarboxylique, et que dans tous les autres cas les combinaisons A)/B) soient possibles,
et que, pour toutes les combinaisons A)/B) et A')/B), la quantité des composants A) ou A') soit choisie de telle sorte que la quantité des radicaux de l'acide thioxanthone-tétracarboxylique, rapportée à la quantité totale des radicaux d'acides tétracarboxyliques dans le mélange de polyimides, soit entre 1,0 et 30 moles %, en particulier entre 1,0 et 20 moles %.

**10.** Compositions comportant les composants A) et B) selon la revendication 9, où dans le composant A) les radicaux $X^a$ qui diffèrent de la formule III et les radicaux $X^c$, dans les deux positions en ortho chaque fois de chacun des deux atomes d'azote, sont substitués avec un alkyle en $C_1$-$C_6$,les groupes carbonyle dans le radical de formule III se trouvent en position 3,3',4,4', $\bar{n}$ a une valeur moyenne de 1,0 à 1,5 et $Z^a$ et éventuellement $Z^b$ sont des radicaux de formule IV ou IX selon la revendication 2, en particulier des radicaux de formule IX, où $R^1$ représente -CO-, -O- ou $-C(CF^3)_2-$ et où dans le

composant B) $Z^d$ et éventuellement $Z^e$ sont des radicaux de formule IV ou IX selon la revendication 2, en particulier des radicaux de formule IX, où $R^1$ représente -O- ou $-C(CF_3)_2-$, $X^j$ est un radical de diamine aromatique bivalent qui, au moins dans une position ortho par rapport aux deux atomes d'azote, est substitué par un alkyle en $C_1$-$C_6$, où au moins 80 moles % des radicaux $Z^d$ et $Z^e$ sont identiques aux radicaux $Z^a$ et $Z^b$ et où au moins 80 moles % des radicaux $X^j$ et éventuellement $X^k$ sont identiques aux radicaux $X^a$ qui diffèrent de la formule III, et éventuellement $X^b$.

**11.** Compositions selon la revendication 10, où le composant A) est constitué de 100 moles % d'unités structurales répétitives de formule I et le composant B) est constitué de 100 moles % d'unités structurales répétitives de formule XXXI et $X^j$ est un radical de diamine aromatique bivalent qui, sur les deux positions en ortho par rapport à chaque fois aux deux atomes d'azote, est substitué par un alkyle en $C_1$-$C_6$.0

**12.** Compositions comportant les composants A') et B) selon la revendication 9, où le composant A') est constitué de 10-60 moles % d'unités structurales répétitives de formule XXVIII et de 90-40 moles % d'unités structurales répétitives de formule XXIX, où dans la formule XXVIII il y a un radical d'acide 3,3', 4,4'-thioxanthone-tétracarboxylique, $Z^d$ et $Z^e$ sont des radicaux d'acide 3,3',4,4'-benzophénone-tétracarboxylique et $X^g$ et $X^h$, indépendamment l'un de l'autre, sont des radicaux de diamines aromatiques bivalents qui, dans au moins une position ortho par rapport aux deux atomes d'azote, sont substitués par un alkyle en $C_1$-$C_6$, où au moins 60 moles % des radicaux $X^j$ et éventuellement $X^k$ sont identiques aux radicaux $X^g$ et $X^h$.

**13.** Compositions selon la revendication 12, où le composant B) est constitué de 100 moles % d'unités structurales répétitives de formule XXXI et $X^g$ et $X^h$, indépendamment l'un de l'autre, sont des radicaux bivalents de diamines aromatiques, qui sont substitués dans les deux positions en ortho par rapport chaque fois aux deux atomes d'azote, avec un alkyle en $C_1$-$C_6$.

**14.** Procédé pour préparer des films de protection ou des structures en relief, comportant les étapes suivantes :

i) on revêt une matière support avec un copolyimide selon la revendication 1, ou avec une composition de polyimides selon la revendication 9

ii) on irradie la matière revêtue avec un échantillon d'un rayonnement actinique, de telle sorte que les parties irradiées de ladite couche de polymère soient réticulées, et,

iii) on développe le système avec un agent de développement approprié.

**15.** Utilisation des copolyimides selon la revendication 1 ou des compositions de polyimides selon la revendication 9 pour préparer des couches d'isolation, de passivation et de protection, et des images en relief.